# EUROPEAN PATENT SPECIFICATION

(11) **EP 2 065 719 B1**
(45) Date of publication and mention of the grant of the patent: **01.07.2015**
(21) Application number: 07708145.3
(22) Date of filing: 07.02.2007
(51) Int. Cl.: G01R 33/09

(54) **MAGNETISM SENSOR**
MAGNETISMUSSENSOR
CAPTEUR DE MAGNÉTISME

(30) Priority: 07.09.2006 JP 2006242997
(43) Date of publication of application: 03.06.2009
(73) Proprietor: Alps Electric Co., Ltd., Tokyo 145-8501 (JP)
(72) Inventor: KIKUIRI, Katsuya, Tokyo 145-8501 (JP)
(74) Representative: Klunker . Schmitt-Nilson . Hirsch
(86) International application number: PCT/JP2007/052106
(87) International publication number: WO 2008/029520

(56) References cited:
- JP-A- 2002 525 947
- JP-A- 2003 014 834
- JP-A- 2003 262 665
- US-A- 5 670 882
- US-B1- 6 304 074

## Description

### Technical Field

The invention relates to a magnetic detector that has a magnetoresistance element and, more particularly, to a bipolar detection-compatible magnetic detector that is able to switch between a single output mode and a dual output mode.

### Background Art

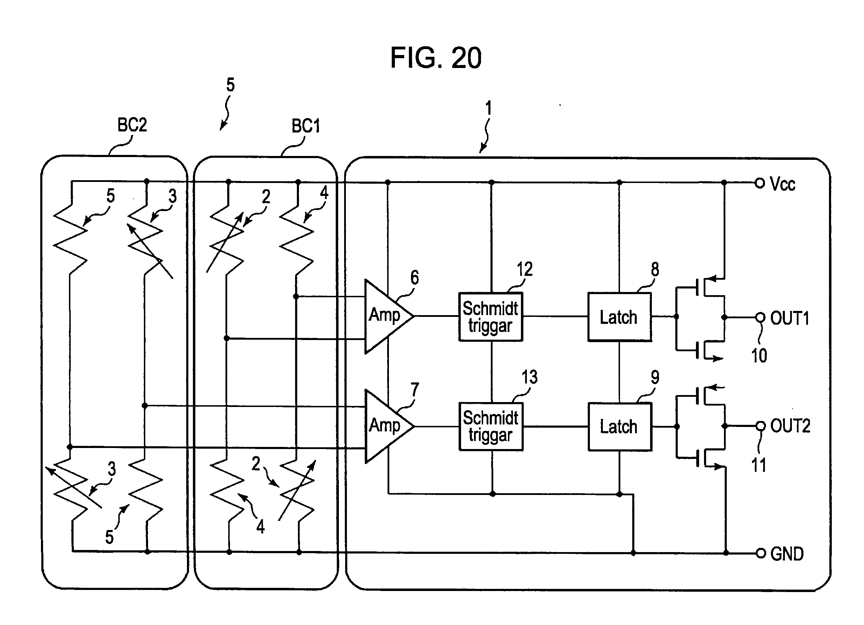

FIG. 20 is a circuit configuration diagram of an existing magnetic detector. The magnetic detector is formed of a sensor portion S and an integrated circuit (IC) 1. The magnetic detector shown in FIG. 20 is a bipolar detection-compatible sensor. The sensor portion S includes a first bridge circuit BC1 and a second bridge circuit BC2. The first bridge circuit BC1 has first magnetoresistance elements 2, such as GMR elements, of which the resistance value varies against an external magnetic field in a (+) direction. The second bridge circuit BC2 has second magnetoresistance elements 3, such as GMR elements, of which the resistance value varies against an external magnetic field in a (-) direction. The "external magnetic field in the (+) direction" indicates an external magnetic field in a selected one direction, and, in the configuration of FIG. 20, indicates an external magnetic field in a direction in which the resistance value of each first magnetoresistance element 2 fluctuates but the resistance value of each second magnetoresistance element 3 does not fluctuate (that is, functions as a fixed resistance). The "external magnetic field in the (-) direction" indicates an external magnetic field in a direction opposite to the external direction in the (+) direction and, in the configuration of FIG. 20, indicates an external magnetic field in a direction in which the resistance value of each second magnetoresistance element 3 fluctuates but the resistance value of each first magnetoresistance element 2 does not fluctuate (that is, functions as a fixed resistance).

As shown in FIG. 20, the first magnetoresistance elements 2 respectively form series circuits with fixed resistance elements 4, and the series circuits are connected in parallel with each other to form the first bridge circuit BC1. Respective output extracting portions of the two series circuits that constitute the first bridge circuit BC1 are connected to a first differential amplifier 6. In addition, as shown in FIG. 20, second magnetoresistance elements 3 respectively form series circuits with fixed resistance elements 5, and the series circuits are connected in parallel with each other to form the second bridge circuit BC2. Respective output extracting portions of the two series circuits that constitute the second bridge circuit BC2 are connected to a second differential amplifier 7.

The integrated circuit 1 includes Schmidt trigger comparators 12 and 13, latch circuits 8 and 9, and the like, in addition to the differential amplifiers 6 and 7. External magnetic field detection signals are extracted from external output terminals 10 and 11.

When an external magnetic field in the (+) direction is applied to the magnetic detector shown in FIG. 20, the resistance value of each first magnetoresistance element 2 that constitutes the first bridge circuit BC1 fluctuates and then the outputs are differentially amplified by the first differential amplifier 6. On the basis of the amplified outputs, a (+) magnetic field detection signal is generated, and the (+) magnetic field detection signal is output from the first external output terminal 10. On the other hand, when an external magnetic field in the (-) direction is applied to the magnetic detector, the resistance value of each second magnetoresistance element 3 that constitutes the second bridge circuit BC2 fluctuates and then the outputs are differentially amplified by the second differential amplifier 7. On the basis of the amplified outputs, a (-) magnetic field detection signal is generated, and the (-) magnetic field detection signal is output from the second external output terminal 11.
As described above, the magnetic detector shown in FIG. 20 serves as a bipolar detection-compatible sensor that is able to detect both an external magnetic field in the (+) direction and an external magnetic field in the (-) direction.
Patent Document 1: Japanese Unexamined Patent Application Publication No. 2004-77374
Patent Document 2: Japanese Unexamined Patent Application Publication No. 2004-180286
Patent Document 3: Japanese Unexamined Patent Application Publication No. 2005-214900
Patent Document 4: Japanese Unexamined Patent Application Publication No. 2003-14833
Patent Document 5: Japanese Unexamined Patent Application Publication No. 2003-14834
Patent Document 6: Japanese Unexamined Patent Application Publication No. 2003-121268
Patent Document 7: Japanese Unexamined Patent Application Publication No. 2004-304052

US 5 670 882 A discloses a target identification system for detecting a desired ferrous object concealed beneath a surface is provided for a gradiometer. The system has first and second sensors for detecting a magnetic field at a first and second points above the surface. A device for providing drive signals for the sensors is connected to the sensors, to generate sensor output signals proportional to the magnetic fields sensed by the sensors. The outputs of the sensors are connected to means for generating a difference signal at an output thereof, the difference signal being the difference between the output signals of the sensors and being proportional to the detected gradient of the magnetic field between the first and second points. An interface receives the difference signal for producing an indication signal when said magnetic field has a selected polarity and when the magnitude of the detected magnetic field gradient exceeds a set value.

For the offset calibration of a magnetoresistive angle sensor for the determination of the directions of magnetic fields, US 6 304 074 B1 discloses a sensor including a Wheatstone bridge with at least four magnetoresistive resistors. The Wheatstone bridge receives an input signal at its input side, in particular an input voltage, and supplies an angle signal at its output side, in particular an angle voltage, in dependence on the direction of a magnetic field which acts on the Wheatstone bridge. The Wheatstone bridge includes a first and a second pair of mutually opposed, substantially parallel magnetoresistive resistors, the first and the second pair being arranged substantially at right angles to one another, while the direction of the magnetic field can be determined from the angle signal supplied by the Wheatstone bridge by means of an evaluation circuit. In a first step the Wheatstone bridge is acted upon by a direct magnetic field which is so aligned that it is neither substantially perpendicular to the magnetoresistive resistors of the first pair nor substantially perpendicular to the magnetoresistive resistors of the second pair of the Wheatstone bridge. In a second step the direct magnetic field is removed, and in a third step an evaluation circuit determines an offset calibration signal, the angle signal supplied by the Wheatstone bridge without direct magnetic field being a measure for the offset of the Wheatstone bridge.

### Disclosure of Invention

### Problems to be Solved by the Invention

The existing magnetic detector shown in FIG. 20 is used in dual output in which a (+) magnetic field detection signal and a (-) magnetic field detection signal are separately output from the first external output terminal 10 and the second external output terminal 11.

At the same time, for example, there is a need for using only the first external output terminal 10 in single output in which both a (+) magnetic field detection signal and a (-) magnetic field detection signal are output from the first external output terminal 10.

In this case, in the existing magnetic detector, it is necessary to reassemble the circuit configuration of the integrated circuit 1 depending on whether it is used in single output or in dual output. This increases cost.

Then, the invention is contemplated to solve the existing problem, and it is an object to provide a bipolar detection-compatible magnetic detector that is able to switch between a single output mode and a dual output mode and, particularly, is able to switch modes with a single integrated circuit and a simple circuit configuration.

### Means for Solving the Problems

A magnetic detector according to the invention includes: a sensor portion of which the electrical characteristic varies against a variation in magnetic field strength of an external magnetic field in a (+) direction and a variation in magnetic field strength of an external magnetic field in a (-) direction opposite to the (+) direction; and an integrated circuit that is connected to the sensor portion and that generates and outputs a (+) magnetic field detection signal and a (-) magnetic field detection signal on the basis of the electrical variation, wherein the integrated circuit includes a first external output terminal, a second external output terminal, and a mode switching portion that is able to switch between a single output mode, in which both the (+) magnetic field detection signal and the (-) magnetic field detection signal are output from the first external output terminal, and a dual output mode, in which the (+) magnetic field detection signal is output from the first external output terminal and the (-) magnetic field detection signal is output from the second external output terminal.

The mode switching portion includes a logic circuit. The mode switching portion is formed using the logic circuit to thereby make it possible to simplify the circuit configuration.

The logic circuit has an NOR circuit or an OR circuit connected to the first external output terminal, when in the single output mode, both high-level and low-level input signals are input to two input portions of the NOR circuit or the OR circuit even at the time of detecting a (+) magnetic field or at the time of detecting a (-) magnetic field and then the same level output signals are output to the first external output terminal as the (+) magnetic field detection signal and the (-) magnetic field detection signal, when in the dual output mode and at the time of detecting a (+) magnetic field, the (+) magnetic field detection signal is output from the first external output terminal, and an output signal of a level inverted from the (+) magnetic field detection signal is output from the second external output terminal as an off signal, and when in the dual output mode and at the time of detecting a (-) magnetic field, the (-) magnetic field detection signal is output from the second external output terminal, and an input signal of a level inverted from that in the single output mode is input to one of the two input portions of the NOR circuit or the OR circuit, and then an output signal of a level inverted from the (-) magnetic field detection signal is output from the first external output terminal as an off signal. Thus, it is possible to appropriately switch between the single output mode and the dual output mode.

With the above configuration, it is possible to form a bipolar detection-compatible magnetic detector that is able to switch between the single output mode and the dual output mode. Particularly, in the invention, the mode switching portion is provided in the integrated circuit to thereby make it possible to form a magnetic detector that enables mode switching using the single integrated circuit with a simple circuit configuration.

In addition, in the invention, it is desirable because it may be implemented with a simple circuit configuration that the mode switching portion has a change-over switch and then the single output mode and the dual output mode are switchable through switching operation of the change-over switch.

In addition, in the invention, it is desirable because it may be implemented with a simple circuit configuration that a change-over switch is connected to the one of the input portions of the NOR circuit and the OR circuit and then a signal level input to the NOR circuit or the OR circuit is inverted through switching operation of the change-over switch to thereby switch between the single output mode and the dual output mode.

In addition, in the invention, desirably, the sensor portion includes a first circuit portion for detecting a (+) magnetic field, which has a first magnetoresistance element that utilizes magnetoresistance effect that electric resistance varies on the basis of a variation in magnetic field strength of an external magnetic field in the (+) direction; and a second circuit portion for detecting a (-) magnetic field, which has a second magnetoresistance element that utilizes magnetoresistance effect that electric resistance varies on the basis of a variation in magnetic field strength of an external magnetic field in the (-) direction opposite to the (+) direction. Thus, it is possible to appropriately form a bipolar detection-compatible sensor portion.

### Advantages

According to the invention, it is possible to provide a bipolar detection-compatible magnetic detector that is able to switch between a single output mode and a dual output mode and, particularly, enables mode switching using a single integrated circuit with a simple circuit configuration.

### Best Modes for Carrying Out the Invention

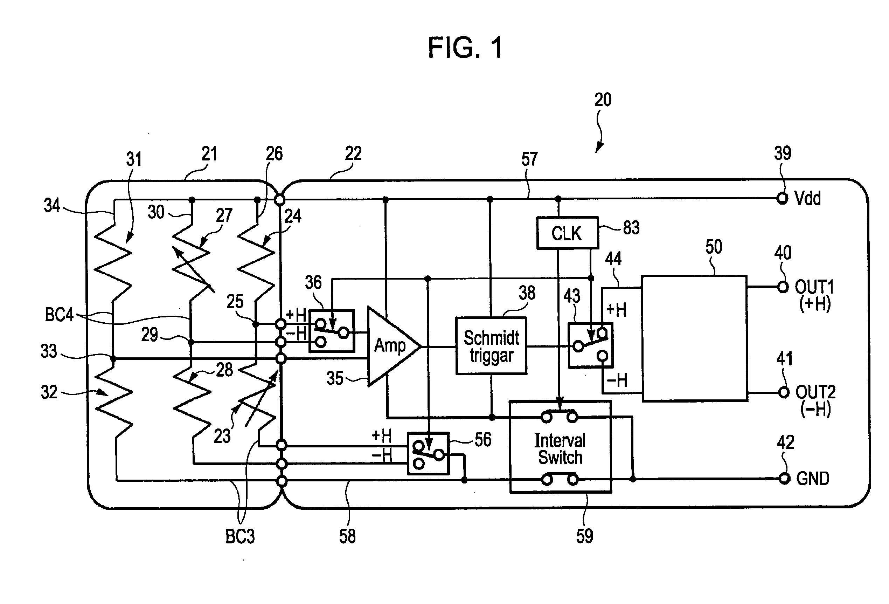

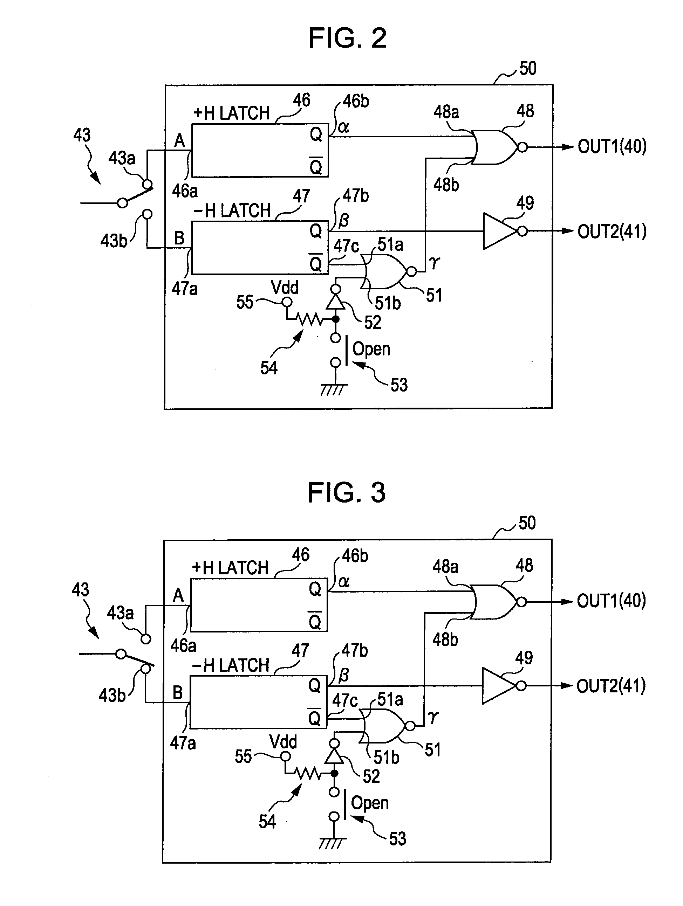

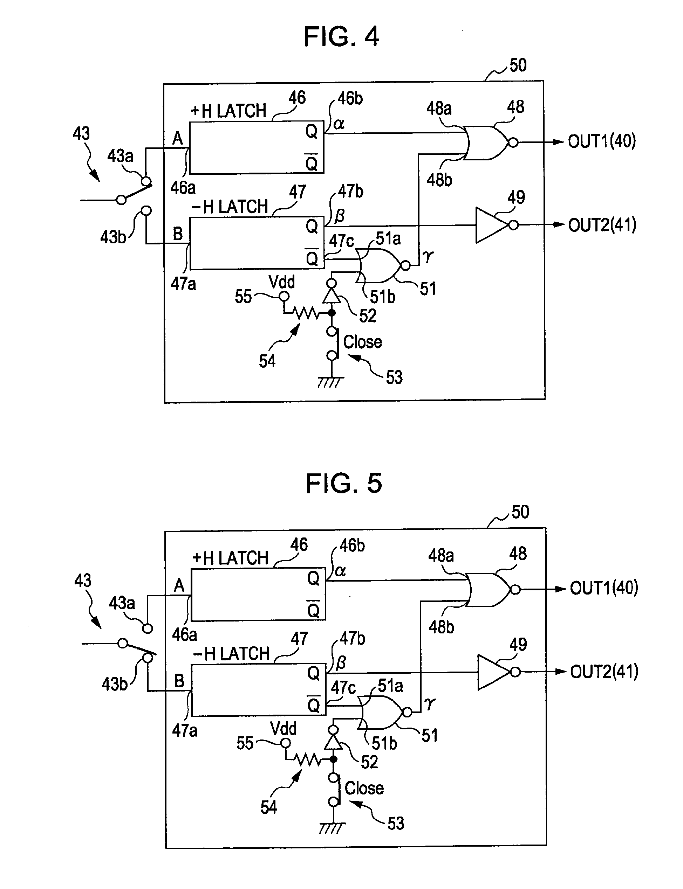

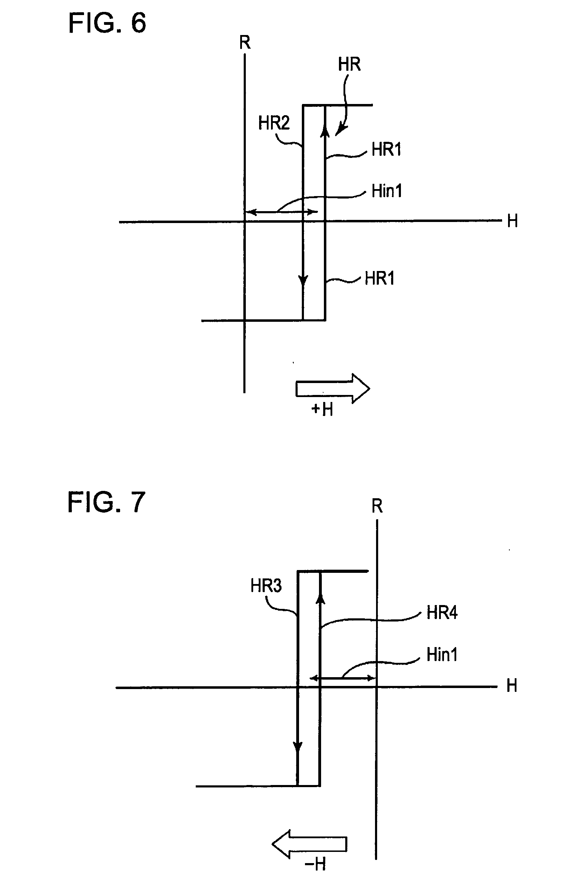

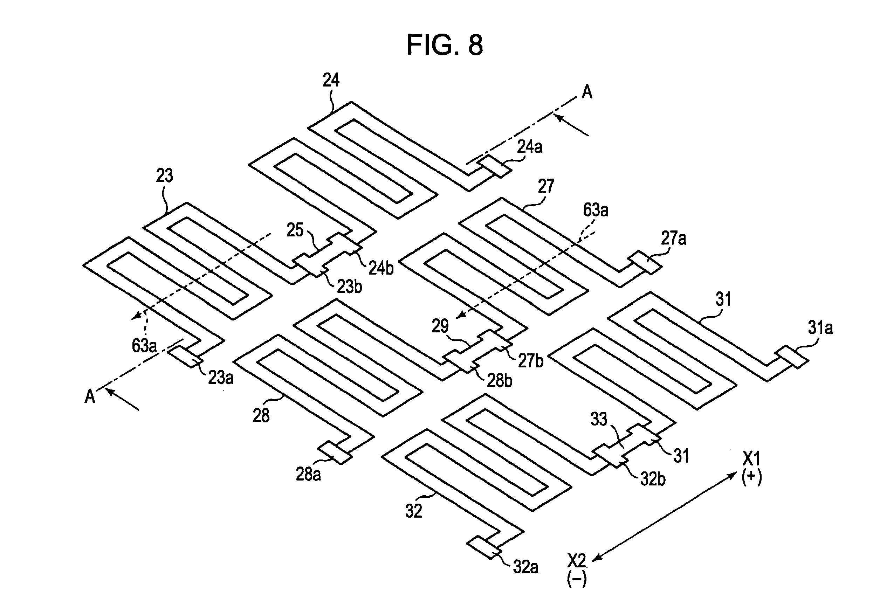

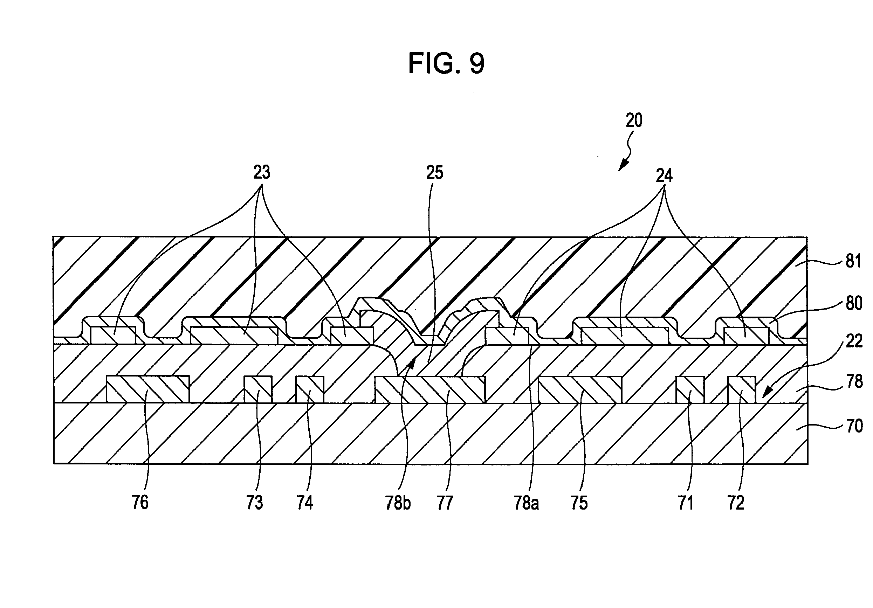

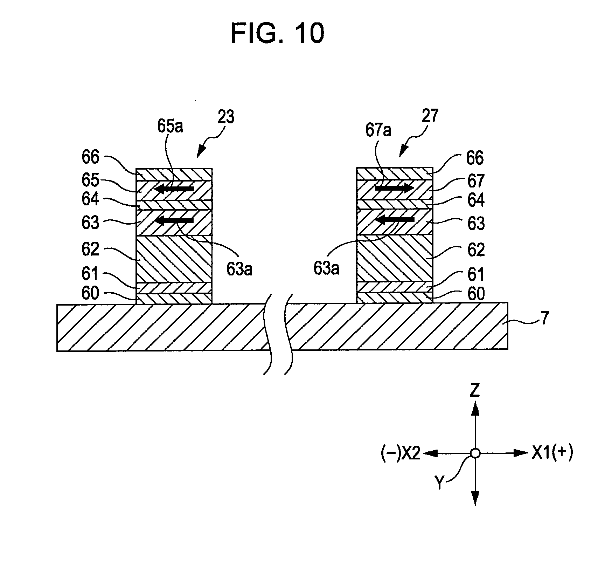

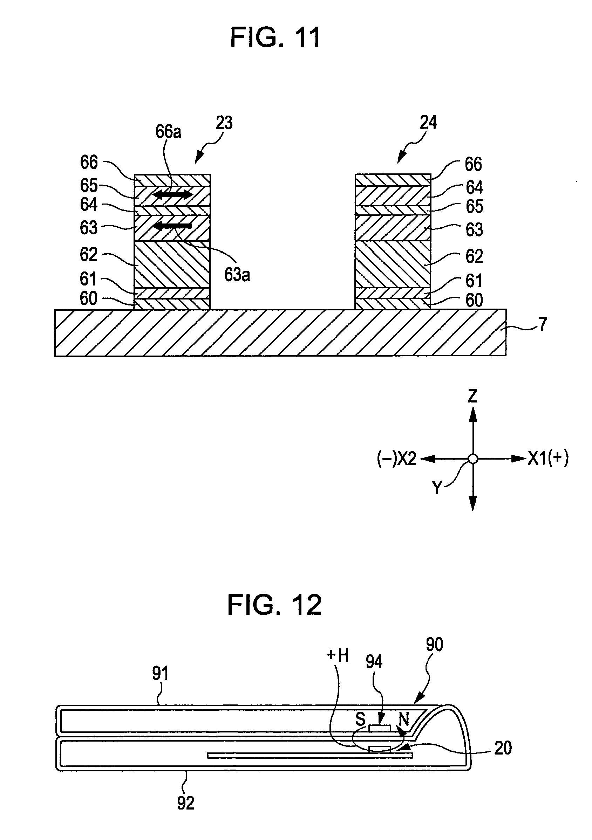

FIG. 1 is an overall circuit configuration diagram of a magnetic detector 20 according to the present embodiment. FIG. 2 to FIG. 5 are partially enlarged views that show the circuit configuration of a mode switching portion in the present embodiment. FIG. 2 shows a circuit state where an external magnetic field in a (+) direction is detected in a single output mode. FIG. 3 shows a circuit state where an external magnetic field in a (-) direction is detected in the single output mode. FIG. 4 shows a circuit state where an external magnetic field in the (+) direction is detected in a dual output mode. FIG. 5 shows a circuit state where an external magnetic field in the (-) direction is detected in the dual output mode. FIG. 6 is a graph (R-H curve) for illustrating the hysteresis characteristic of a first magnetoresistance element. FIG. 7 is a graph (R-H curve) for illustrating the hysteresis characteristic of a second magnetoresistance element. FIG. 8 is a partially enlarged perspective view of the magnetic detector 20 that shows the shape of resistance elements of a sensor portion of the magnetic detector 20 according to the present embodiment. FIG. 9 is a partially cross-sectional view of the magnetic detector, taken along the line A-A in the thickness direction in FIG. 8, as viewed in an arrow direction. FIG. 10 is a partially cross-sectional view that shows the layer structures of the first magnetoresistance element and the second magnetoresistance element. FIG. 11 is a partially cross-sectional view for mainly illustrating the layer structure of a fixed resistance element. FIG. 12 to FIG. 19 are examples for illustrating applications of the magnetic detector according to the present embodiment, and are partially schematic views and partially plan views of a folding cellular phone having the magnetic detector as internals.

The magnetic detector 20 according to the present embodiment shown in FIG. 1 includes a sensor portion 21 and an integrated circuit (IC) 22.

The sensor portion 21 includes a first series circuit 26 in which a first resistance element (first magnetoresistance element) 23 and a second resistance element (fixed resistance element in the present embodiment) 24 are connected in series via a first output extracting portion (connecting portion) 25, a second series circuit 30 in which a third resistance element (second magnetoresistance element) 27 and a fourth resistance element (fixed resistance element in the present embodiment) 28 are connected in series via a second output extracting portion (connecting portion) 29, and a third series circuit 34 in which a fifth resistance element (fixed resistance element in the present embodiment) 31 and a sixth resistance element (fixed resistance element in the present embodiment) 32 are connected in series via a third output extracting portion 33.

Note that as described above, the "resistance elements" are denoted by serial numbers first to sixth. Note that, in the following description, the resistance elements are mainly referred to as "magnetoresistance elements" and "fixed resistance elements", and, when it is not necessary to describe separately the "magnetoresistance element" and the "fixed resistance elements", referred to as "resistance elements".

The third series circuit 34 serves as a common circuit to constitute bridge circuits respectively with the first series circuit 26 and the second series circuit 30. Hereinafter, the bridge circuit formed by connecting the first series circuit 26 and the third series circuit 34 in parallel is termed as a first bridge circuit BC3, the bridge circuit formed by connecting the second series circuit 30 and the third series circuit 34 in parallel is termed as a second bridge circuit BC4.

As shown in FIG. 1, in the first bridge circuit BC3, the first resistance element 23 and the sixth resistance element 32 are connected in parallel, and the second resistance element 24 and the fifth resistance element 31 are connected in parallel. In addition, in the second bridge circuit BC4, the third resistance element 27 and the fifth resistance element 31 are connected in parallel, and the fourth resistance element 28 and the sixth resistance element 32 are connected in parallel.

As shown in FIG. 1, the integrated circuit 22 includes an input terminal (power source) 39, a ground terminal 42 and two external output terminals 40 and 41. The input terminal 39, the ground terminal 42 and the external output terminals 40 and 41 each are electrically connected to a device-side terminal portion (not shown) through a wire bonding, a die bonding, or the like.

A signal line 57 connected to the input terminal 39 and a signal line 58 connected to the ground terminal 42 each are connected to electrodes provided at both end portions of the first series circuit 26, second series circuit 30 and third series circuit 34.

As shown in FIG. 1, the integrated circuit 22 includes a single differential amplifier (differential output portion) 35, and the third output extracting portion 33 of the third series circuit 34 is connected to any one of the (+) input portion and (-) input portion of the differential amplifier 35. Note that connection of the third output extracting portion 33 with the differential amplifier 35 is fixed (does not enter a non-connected state), different from a connection state between the first output extracting portion 25 of the first series circuit 26 or the second output extracting portion 29 of the second series circuit 30 and the differential amplifier 35, which will be described below.

The first output extracting portion 25 of the first series circuit 26 and the second output extracting portion 29 of the second series circuit 30 each are connected to input portions of a first switch circuit (first connection switching portion) 36. The output portion of the first switch circuit 36 is connected to any one of the (-) input portion and (+) input portion of the differential amplifier 35 (input portion at the side the third output extracting portion 33 is not connected).

As shown in FIG. 1, the output portion of the differential amplifier 35 is connected to a Schmidt trigger comparator 38, and the output portion of the comparator 38 is further connected to the input portion of a second switch circuit (second connection switching portion) 43. Furthermore, the output portion side of the second switch circuit 43 is connected to each of a first external output terminal 40 and a second external output terminal 41 via a mode switching portion 50, which will be described later.

Furthermore, as shown in FIG. 1, the integrated circuit 22 includes a third switch circuit 56. The output portion of the third switch circuit 56 is connected to the signal line 58 that is connected to the ground terminal 42, and the negative terminals of the first series circuit 26 and second series circuit 30 are connected to the input portions of the third switch circuit 56.

Furthermore, as shown in FIG. 1, the integrated circuit 22 includes an interval switch circuit 59 and a clock circuit 83. As the switch of the interval switch circuit 59 is turned off, supply of electric current to the integrated circuit 22 is stopped. The on/off of the switch of the interval switch circuit 59 is interlocked with a clock signal from the clock circuit 83, and the interval switch circuit 59 has a power saving function of intermittently supplying electric current.

The clock signal from the clock circuit 83 is output also to the first switch circuit 36, the second switch circuit 43 and the third switch circuit 56. When the first switch circuit 36, the second switch circuit 43 and the third switch circuit 56 receive the clock signal, they are controlled to divide the clock signal and performs switching at extremely short intervals. For example, when one-pulse clock signal takes several tens of msec, switching is performed at every several tens of µsec.

The first magnetoresistance element 23 is a magnetoresistance element that exhibits magnetoresistance effect on the basis of a variation in strength of an external magnetic field (+H) in a (+) direction, while the second magnetoresistance element 27 is a magnetoresistance element that exhibits magnetoresistance effect on the basis of a variation in magnetic field strength of an external magnetic field (-H) in a (-) direction opposite to the (+) direction.

Here, the external magnetic field in the (+) direction indicates a direction and, in the present embodiment, is a direction pointing an X1 direction in the drawing. When the external magnetic field in the above direction is applied, as illustrated in FIG. 6 and FIG. 7, the resistance value of the first magnetoresistance element 23 fluctuates, whereas the resistance value of the second magnetoresistance element 27 does not fluctuate (that is, functions as a fixed resistance).

On the other hand, the external magnetic field in the (-) direction is an external magnetic field in a direction opposite to the (+) direction, and is a direction pointing an X2 direction in the drawing. When the external magnetic field in the above direction is applied, as illustrated in FIG. 6 and FIG. 7, the resistance value of the second magnetoresistance element 27 fluctuates, whereas the resistance value of the first magnetoresistance element 23 does not fluctuate (that is, functions as a fixed resistance).

The layer structure and hysteresis characteristic of each of the first magnetoresistance element 23 and the second magnetoresistance element 27 will be described in detail below.

As shown in FIG. 10, the first magnetoresistance element 23 and the second magnetoresistance element 27 each are formed by laminating, from the bottom, a base layer 60, a seed layer 61, an antiferromagnetic layer 62, a fixed magnetic layer 63, a nonmagnetic interlayer 64, a free magnetic layer 65 or 67 (the free magnetic layer of the second magnetoresistance element 27 is denoted by the reference numeral 37), and a protective layer 66. The base layer 60 is, for example, formed of a nonmagnetic material, such as one or two or more elements selected from Ta, Hf, Nb, Zr, Ti, Mo and W. The seed layer 61 is formed of NiFeCr, Cr, or the like. The antiferromagnetic layer 62 is formed of an antiferromagnetic material containing an element α (where α is one or two or more elements selected from Pt, Pd, Ir, Rh, Ru and Os) and Mn or an antiferromagnetic containing the element α, an element α' (where the element α' is one or two or more elements selected from Ne, Ar, Kr, Xe, Be, B, C, N, Mg, Al, Si, P, Ti, V, Cr, Fe, Co, Ni, Cu, Zn, Ga, Ge, Zr, Nb, Mo, Ag, Cd, Sn, Hf, Ta, W, Re, Au, Pb and rare-earth elements) and Mn. For example, the antiferromagnetic layer 62 is formed of IrMn or PtMn. The fixed magnetic layer 63 and the free magnetic layer 65 or 67 are formed of a magnetic material, such as a CoFe alloy, a NiFe alloy and a CoFeNi alloy. In addition, the nonmagnetic interlayer 64 is formed of Cu, or the like. In addition, the protective layer 66 is formed of Ta, or the like. The fixed magnetic layer 63 and the free magnetic layers 65 and 67 may have a laminated ferri structure (laminated structure formed of magnetic layer/nonmagnetic layer/magnetic layer, and the magnetized directions of the two magnetic layers that place the nonmagnetic layer in between are antiparallel). In addition, the fixed magnetic layer 63 and the free magnetic layers 65 and 67 may have a laminated structure of a plurality of magnetic layers having different materials.

In the first magnetoresistance element 23 and the second magnetoresistance element 27, the antiferromagnetic layer 62 and the fixed magnetic layer 63 are formed in contact with each other. Thus, with heat treatment in magnetic field, an exchange coupling magnetic field (Hex) is generated at an interface between the antiferromagnetic layer 62 and the fixed magnetic layer 63, and the magnetized direction of the fixed magnetic layer 63 is fixed in one direction. In FIG. 8 and FIG. 10, the magnetized directions 63a of the fixed magnetic layers 63 are indicated in the arrow direction. In the first magnetoresistance element 23 and the second magnetoresistance element 27, the magnetized directions 63a of the fixed magnetic layers 63 both are in the X1 direction ((+) direction) in the drawing.

On the other hand, the magnetized directions of the free magnetic layers 65 and 67 are different between the first magnetoresistance element 23 and the second magnetoresistance element 27. As shown in FIG. 10, in the first magnetoresistance element 23, the magnetized direction 65a of the free magnetic layer 65 is the X2 direction ((-) direction) in the drawing and is the same as the magnetized direction 63a of the fixed magnetic layer 63, whereas in the second magnetoresistance element 27, the magnetized direction 67a of the free magnetic layer 67 is the X1 direction ((+) direction) in the drawing and is antiparallel with the magnetized direction 63a of the fixed magnetic layer 63.

When an external magnetic field in the (+) direction is applied, the magnetization 67a of the free magnetic layer 67 of the second magnetoresistance element 27 does not fluctuate, whereas the magnetization 65a of the free magnetic layer 65 of the first magnetoresistance element 23 fluctuates and, therefore, the resistance value of the first magnetoresistance element 23 varies. FIG. 6 is an R-H curve that shows the hysteresis characteristic of the first magnetoresistance element 23. Note that in the graph in the drawing, the ordinate axis represents a resistance value R; instead, it may be a rate of change in resistance (%). As shown in FIG. 6, as the external magnetic field gradually increases from a non-magnetic field state (zero) in the (+) direction, the parallel state between the magnetization 65a of the free magnetic layer 65 and the magnetization 63a of the fixed magnetic layer 63 collapses to approach an antiparallel state, so the resistance value R of the first magnetoresistance element 23 gradually increases along a curve HR1, whereas as the external magnetic field in the (+) direction is gradually reduced toward zero, the resistance value R of the first magnetoresistance element 23 gradually decreases along a curve HR2.

In this way, the first magnetoresistance element 23 has formed a hysteresis loop HR, surrounded by the curve HR1 and the curve HR2, against a variation in magnetic field strength of an external magnetic field in the (+) direction. A "median" of the hysteresis loop HR is a median value between the maximum resistance value and the minimum resistance value of the first magnetoresistance element 23 and is a median value within the spread of the hysteresis loop HR. Then, the strength of a magnetic field from the median of the hysteresis loop HR to a line at the external magnetic field H = 0 (Oe) determines the magnitude of a first interlayer coupling magnetic field Hin1. As shown in FIG. 6, in the first magnetoresistance element 23, the first interlayer coupling magnetic field Hin1 is shifted in a positive magnetic field direction.

On the other hand, when an external magnetic field in the (-) direction is applied, the magnetization 65a of the free magnetic layer 65 of the first magnetoresistance element 23 does not fluctuate, whereas the magnetization 67a of the free magnetic layer 67 of the second magnetoresistance element 27 fluctuates and, therefore, the resistance value of the second magnetoresistance element 27 varies.

FIG. 7 is an R-H curve that shows the hysteresis characteristic of the second magnetoresistance element 27. As shown in FIG. 7, as the external magnetic field gradually increases from a non-magnetic field state (zero) in the (-) direction, the antiparallel state between the magnetization 67a of the free magnetic layer 67 and the magnetization 63a of the fixed magnetic layer 63 collapses to approach a parallel state, so the resistance value R of the second magnetoresistance element 27 gradually decreases along a curve HR3, whereas as the external magnetic field in the (-) direction is gradually reduced toward zero, the resistance value R of the second magnetoresistance element 27 gradually increases along a curve HR4.

In this way, the second magnetoresistance element 27 has formed a hysteresis loop HR, surrounded by the curve HR3 and the curve HR4, against a variation in magnetic field strength of an external magnetic field in the (-) direction. A "median" of the hysteresis loop HR is a median value between the maximum resistance value and the minimum resistance value of the second magnetoresistance element 27 and is a median value within the spread of the hysteresis loop HR. Then, the strength of a magnetic field from the median of the hysteresis loop HR to a line at the external magnetic field H = 0 (Oe) determines the magnitude of a second interlayer coupling magnetic field Hin2. As shown in FIG. 7, in the second magnetoresistance element 27, the second interlayer coupling magnetic field Hin2 is shifted in a negative magnetic field direction.

In this way, in the present embodiment, the first interlayer coupling magnetic field Hin1 of the first magnetoresistance element 23 is shifted in the positive magnetic field direction, while the second interlayer coupling magnetic field Hin2 of the second magnetoresistance element 27 is shifted in the negative magnetic field direction.

To obtain the mutually inverted sign interlayer coupling magnetic fields Hin1 and Hin2 illustrated in FIG. 6 and FIG. 7, for example, it is only necessary to appropriately adjust the flow rate of gas (gas pressure) and/or electric power when plasma treatment (PT) is applied to the surface of the nonmagnetic interlayer 64. It is known that the interlayer coupling magnetic field Hin varies depending on the flow rate of gas (gas pressure) and the magnitude of electric power. As the flow rate of gas (gas pressure) or the electric power is increased, the interlayer coupling magnetic field Hin may be varied from a positive value to a negative value. In addition, the magnitude of the interlayer coupling magnetic field Hin also varies depending on the thickness of the nonmagnetic interlayer 64. Alternatively, when laminated, from the bottom, the antiferromagnetic layer, the fixed magnetic layer, the nonmagnetic interlayer and the free magnetic layer, the magnitude of the interlayer coupling magnetic field Hin may be adjusted by changing the thickness of the antiferromagnetic layer.

In the first magnetoresistance element 23, the first interlayer coupling magnetic field Hin1 is positive, and in this case, interaction to parallel the mutual magnetizations acts between the fixed magnetic layer 63 and the free magnetic layer 65. In addition, in the second magnetoresistance element 27, the second interlayer coupling magnetic field Hin2 is negative, and in this case, interaction to antiparallel the mutual magnetizations acts between the fixed magnetic layer 63 and the free magnetic layer 67. Then, the exchange coupling magnetic fields (Hex) in the same direction are generated between the antiferromagnetic layers 62 and the fixed magnetic layers 63 of the respective magnetoresistance elements 23 and 27 through heat treatment in a magnetic field. Thus, the magnetizations 63a of the fixed magnetic layers 63 of the respective magnetoresistance elements 23 and 27 may be fixed in the same direction, and, in addition, the above described interaction acts between the fixed magnetic layers 63 and the free magnetic layers 65 and 67, thus entering a magnetized state shown in FIG. 10.

The above described first magnetoresistance element 23 and second magnetoresistance element 27 utilize great magnetoresistance effect (GMR effect); instead, other than the GMR element, they may be an AMR element that utilizes anisotropic magnetoresistance effect (AMR) or a TMR element that utilizes tunnel magnetoresistance effect (TMR).

On the other hand, the fixed resistance element 24 that is connected in series with the first magnetoresistance element 23 differs from the first magnetoresistance element 23 only in that the order of lamination, and is formed of the same material layers as those of the first magnetoresistance element 23. That is, as shown in FIG. 11, the fixed resistance element 24 is laminated in order of, from the bottom, the base layer 60, the seed layer 61, the antiferromagnetic layer 62, a first magnetic layer 63, a second magnetic layer 65, the nonmagnetic interlayer 64 and the protective layer 66. The first magnetic layer 63 corresponds to the fixed magnetic layer 63 that constitutes the first magnetoresistance element 23, and the second magnetic layer 65 corresponds to the free magnetic layer 65 that constitutes the first magnetoresistance element 23. As shown in FIG. 11, in the fixed resistance element 23, the first magnetic layer 63 and the second magnetic layer 65 are continuously laminated on the antiferromagnetic layer 62, and the magnetizations of the first magnetic layer 63 and the second magnetic layer 65 both are fixed by the exchange coupling magnetic field (Hex) generated with the antiferromagnetic layer 62. The second magnetic layer 65 does not fluctuate in magnetization against an external magnetic field as in the case of the free magnetic layer 65 of the first magnetoresistance element 23.

As shown in FIG. 11, layers of the fixed resistance element 24 are formed of the same materials as the layers corresponding to the first magnetoresistance element 23. Thus, the element resistances of the first magnetoresistance element 23 and the fixed resistance element 24 are substantially equal. In addition, it is possible to suppress variations between the temperature coefficient (TCR) of the first magnetoresistance element 23 and the temperature coefficient of the fixed resistance element 23. As a result, it is possible to suppress variations in median potential against a variation in temperature to make it possible to improve stability of operations. Note that it is more desirable that not only the materials but also the thickness of each layer corresponding to the first magnetoresistance element 23 is equal to that of each layer of the first magnetoresistance element 23.

Although not shown in the drawing, as in the case of the above, the fixed resistance element 28 that is connected in series with the second magnetoresistance element 27 differs from the second magnetoresistance element 27 only in that the order of lamination, and is formed of the same material layers as those of the second magnetoresistance element 27.

In addition, the layer structures of the fixed resistance elements 31 and 32 that constitute the third series circuit 34 are not specifically limited as long as they are resistance elements formed of the mutually same material layers and have substantially the same element resistance. That is, the fixed resistance elements 31 and 32 may be, for example, formed in a single-layer structure formed of a resistance material having a high sheet resistance. However, it is desirable because a manufacturing process may be simplified when the fixed resistance elements 31 and 32 are formed at the same time in a process in which the fixed resistance elements 24 and 28 that respectively form the first series circuit 26 and the second series circuit 30 are formed. Thus, it is desirable that, as well as the fixed resistance elements 24 and 28 of the first series circuit 26 and second series circuit 30, the fixed resistance elements 31 and 32 are formed of the same material layers as those of the first magnetoresistance element 23 or the second magnetoresistance element 27 but are different from the first magnetoresistance element 23 or the second magnetoresistance element 27 only in that the order of lamination.

Next, the cross-sectional shape of the magnetic detector 20 according to the present embodiment will be described with reference to FIG. 9. As shown in FIG. 9, the magnetic detector 20 is formed so that a silica (SiO₂) base film (not shown) is formed on a substrate 70 made of, for example, silicon (Si) in certain thickness.

Active elements 71 to 74, such as the differential amplifier and the comparator, resistors 75 and 76, a wiring layer (signal line) 77, and the like, that constitute the integrated circuit 22 are formed on the base film. The wiring layer 77 is, for example, made of aluminum (Al).

As shown in FIG. 9, the substrate 70 and the integrated circuit 22 are covered with an insulating layer 78 formed of a resist layer, or the like. The insulating layer 78 has a hole 78b that is partially formed on the wiring layer 77, and the upper surface of the wiring layer 78 is exposed through the hole 78b.

The surface 78a of the insulating layer 78 is formed by a planarizing surface, and the first magnetoresistance element 23, the second magnetoresistance element 27 and the fixed resistance elements 24, 28, 31 and 32 are formed on the planarized surface 78a of the insulating layer 78 in a meander shape as shown in FIG. 8. Thus, the element resistance of each element is increased to make it possible to reduce current consumption.

As shown in FIG. 8, electrodes 23a, 23b, 24a, 24b, 27a, 27b, 28a, 28b, 32a, 32b, 33a and 33b are formed at both ends of the respective elements. The electrode 23b of the first magnetoresistance element 23 is connected to the electrode 24b of the fixed resistance element 24 by the first output extracting portion 25. the first output extracting portion 25 is electrically connected onto the wiring layer 77 as shown in FIG. 9. Similarly, the electrode 27b of the second magnetoresistance element 27 is connected to the electrode 28b of the fixed resistance element 28 by the second output extracting portion 29. The second output extracting portion 29 is electrically connected to the wiring layer (not shown). The electrode 32b of the fixed resistance element 32 is connected to the electrode 31b of the fixed resistance element 31 by the third output extracting portion 33. The third output extracting portion 33 is electrically connected to the wiring layer (not shown).

As shown in FIG. 9, the elements, the electrodes and the output extracting portions are, for example, covered with an insulating layer 80 made of alumina or silica. Then, the magnetic detector 20 is packaged by a molded resin 81.

The magnetic detector 20 according to the present embodiment is a bipolar detection-compatible sensor and is able to select which mode is used, a single output mode or a dual output mode.

The "single output mode" is a mode in which both a (+) magnetic field detection signal and a (-) magnetic field detection signal are output from the first external output terminal 40. The "dual output mode" is a mode in which the (+) magnetic field detection signal is output from the first external output terminal 40 and the (-) magnetic field detection signal is output from the second external output terminal 41. In the "single output mode", of course, both the (+) magnetic field detection signal and the (-) magnetic field detection signal may be output from the second external output terminal 41. In the present embodiment, it is defined that, in the "single output mode", the external output terminal that outputs both the (+) magnetic field detection signal and the (-) magnetic field detection signal is the "first external output terminal". Then, it is defined that, in the dual output mode, the magnetic field detection signal output from the first external output terminal is the (+) magnetic field detection signal, and a circuit portion at which an electrical variation for generating the (+) magnetic field detection signal occurs is a (+) magnetic field detection circuit.

The mode switching portion 50, which is a characteristic portion of the magnetic detector according to the present embodiment, will be described. As shown in FIG. 2 to FIG. 5, the mode switching portion 50 includes a logic circuit. The logic circuit is formed of a combination of latch circuits 46 and 47, which are storage circuits, and NOR circuits and NOT circuits, which are basic logic circuits.

The first latch circuit 46 is provided between the second switch circuit 43 and the first external output terminal 40, and the (+) magnetic field detection side terminal 43a of the second switch circuit 43 is connected to the input portion 46a of the first latch circuit 46. In addition, the second latch circuit 47 is provided between the second switch circuit 43 and the second external output terminal 41, and the (-) magnetic field detection side terminal 43b of the second switch circuit 43 is connected to the input portion 47a of the second latch circuit 47.

As shown in FIG. 2 to FIG. 5, the first output portion 46b of the first latch circuit 46 is connected to the first input portion 48a of the first NOR circuit 48, which is a basic logic circuit. The first output portion 46b of the first latch circuit 46 is a side at which a signal having the same level as an input signal input from the input portion 46a of the first latch circuit 46 is output. Then, the output portion of the first NOR circuit 48 is connected to the first external output terminal 40.

In addition, as shown in FIG. 2 to FIG. 5, the first output portion 47b of the second latch circuit 47 is connected to the input portion of the first NOT circuit 49, which is a basic logic circuit. Then, the output portion of the first NOT circuit 49 is connected to the second external output terminal 41.

The first output portion 47b of the second latch circuit 47 is a side at which a signal having the same level as an input signal input from the input portion 47a of the second latch circuit 47 is output. On the other hand, the second output portion 47c of the second latch circuit 47 is a side at which a signal having a level inverted from an input signal input to the input portion 47a is output.

As shown in FIG. 2 to FIG. 5, the second output portion 47c of the second latch circuit 47 is connected to the first input portion 51a of the second NOR circuit 51, and the output portion of the second NOR circuit 51 is connected to the second input portion 48b of the first NOR circuit 48.

As shown in FIG. 2 to FIG. 5, the second input portion 51b of the second NOR circuit 51 is connected to the second NOT circuit 52. An input portion side signal line of the second NOT circuit 52 is divided into two. One of the signal lines is connected to a power source portion 55 through a resistance element 54, and the other signal line is connected to a ground through a change-over switch 53.

Both the circuit configurations of FIG. 2 and FIG. 3 show a circuit configuration diagram in the single output mode. As shown in FIG. 2 and FIG. 3, in the single output mode, the change-over switch 53 is in an open state (off state). On the other hand, FIG. 4 and FIG. 5 both show a circuit configuration diagram in the dual output mode. As shown in FIG. 4 and FIG. 5, in the dual output mode, the change-over switch 53 is in a closed state (on state).

Next, the principles of how a signal is transferred to the second switch circuit 43 will be described. First, the case in which no external magnetic field is applied to the magnetic detector 20 according to the present embodiment will be described. In this case, the resistance values of the first magnetoresistance element 23 and the second magnetoresistance element 27 both do not vary. When the first switch circuit 36, the second switch circuit 43 and the third switch circuit 56 each receive a clock signal from the clock circuit 83, as shown in FIG. 1, it switches at several tens of µsec between a (+) direction external magnetic field detection circuit in which the first switch circuit 36 connects the first output extracting portion 25 of the first series circuit 26 with the differential amplifier 35, the second switch circuit 43 connects the comparator 38 with the first external output terminal 40 and the third switch circuit 56 connects the first series circuit 26 with the ground terminal 42 and a (-) direction external magnetic field detection circuit in which the first switch circuit 36 connects the second output extracting portion 29 of the second series circuit 30 with the differential amplifier 35, the second switch circuit 43 connects the comparator 38 with the second external output terminal 41 and the third switch circuit 56 connects the second series circuit 30 with the ground terminal 42.

When no external magnetic field is applied, in the state of the (+) direction external magnetic field detection circuit, a differential potential between the first output extracting portion 25 of the first bridge circuit BC3 and the third output extracting portion 33 is substantially zero, and in the state of the (-) direction external magnetic field detection circuit, a differential potential between the second output extracting portion 29 of the second bridge circuit BC4 and the third output extracting portion 33 is substantially zero. As an output having a differential potential of zero is output from the differential amplifier 35 to the comparator 38, the output is Schmidt trigger input in the comparator 38 to generate a low-level signal (0 signal). Note that even when an external magnetic field is applied, if it is smaller than a predetermined magnitude, variations in the first magnetoresistance element 23 and the second magnetoresistance element 27 both are small and, a low-level signal (0 signal) is generated as in the case when no external magnetic field is applied.

On the other hand, as the (+) direction external magnetic field is applied to the magnetic detector 20 according to the present embodiment, the resistance value of the first magnetoresistance element 23 fluctuates, and then a median potential in the first output extracting portion 25 of the first series circuit 26 fluctuates (when the circuit configuration of FIG. 1 has the hysteresis characteristic shown in FIG. 6, the potential specifically increases).

Now, in the state of the (+) direction external magnetic field detection circuit, the median potential of the third output extracting portion 33 of the third series circuit 34 is set as a reference potential, a differential potential between the first output extracting portion 25 and the third output extracting portion 33 of the first bridge circuit BC3, formed of the first series circuit 26 and the third series circuit 34, is generated in the differential amplifier 35 and output to the comparator 38. In the comparator 38, the differential potential is shaped into a pulse-like waveform signal through Schmidt trigger input. At this time, when the external magnetic field in the (+) direction is larger than or equal to a predetermined magnitude, the shaped signal is generated as a high-level signal (1-signal) on the basis of the differential potential.

Similarly, when an external magnetic field in the (-) direction is applied to the magnetic detector 20 according to the present embodiment, the resistance value of the second magnetoresistance element 23 fluctuates and then the median potential in the second output extracting portion 29 of the second series circuit 30 fluctuates (when the circuit configuration of FIG. 1 has the hysteresis characteristic shown in FIG. 7, the potential specifically increases).

Now, in the state of the (-) direction external magnetic field detection circuit, the median potential of the third output extracting portion 33 of the third series circuit 34 is set as a reference potential, a differential potential between the second output extracting portion 29 and the third output extracting portion 33 of the second bridge circuit BC4, formed of the second series circuit 30 and the third series circuit 34, is generated in the differential amplifier 35 and output to the comparator 38. In the comparator 38, the differential potential is shaped into a pulse-like waveform signal through Schmidt trigger input. At this time, when the external magnetic field in the (-) direction is larger than or equal to a predetermined magnitude, the shaped signal is generated as a high-level signal (1-signal) on the basis of the differential potential.

Next, the principles of detecting an external magnetic field in the (+) direction in the single output mode will be described with reference to FIG. 2. Note that in the following description, where a signal at the input portion 46a of the first latch circuit 46 is denoted by "A", a signal at the input portion 47a of the second latch circuit 47 is denoted by "B", a signal at the first output portion 46b of the first latch circuit 46 is denoted by "α", a signal at the first output portion 47b of the second latch circuit 47 is denoted by "β", a signal at the output portion of the second NOR circuit 51 is denoted by "γ", a signal at the first external output terminal 40 is denoted by "OUT1", and a signal at the second external output terminal 41 is denoted by "OUT2", the level of each signal is shown in the following Table 1 (single output mode).
[Table 1]

**Table 1**

| Single Output Mode | | | | | | | |
|---|---|---|---|---|---|---|---|
| EXTERNAL MAGNETIC FIELD | A | B | α | β | γ | OUT1 | OUT2 |
| +H | H | L | H | L | L | L (ON) | H (OFF) |
| -H | L | H | L | H | H | L(ON) | L (ON) |
| NON | L | L | L | L | L | H (OFF) | H (OFF) |

| | | | | | | | |
|---|---|---|---|---|---|---|---|
| L: Low level H: High level "H" shown in Table 1 denotes a high-level signal (1-signal), and "L" denotes a low-level signal (0-signal). | | | | | | | |

As described above, in the single output mode, the change-over switch 53 is in an open state. Then, in the single output mode and at the time of detecting a (+) magnetic field, the signal level of each portion is shown in the "external magnetic field" column in the upper row (+H row) in Table 1.

In the state of the (+) direction external magnetic field detection circuit, as shown in FIG. 2, the (+) magnetic field detection side terminal 43a of the second switch circuit 43 is connected to the input portion 46a of the first latch circuit 46.

As described above, in a state where an external magnetic field in the (+) direction larger than a predetermined magnitude is applied, a high-level signal (1-signal) is generated in the comparator 38 and is then input to the input portion 46a of the first latch circuit 46. On the other hand, because the change-over switch 53 is in an open state, a high-level input signal is input to the input portion of the second NOT circuit 52, and a low-level input signal is input from the output portion of the second NOT circuit 52 to the second input portion 51b of the second NOR circuit 51. Then, a high-level input signal is input from the second output portion 47c of the second latch circuit 47 to the first input portion 51a of the second NOR circuit 51. As a result, a low-level input signal is input from the output portion of the second NOR circuit 51 to the second input portion 48b of the first NOR circuit 48 (γ column in the upper row in Table 1). On the other hand, as shown in the column α in the upper row in Table 1, a high-level input signal is input from the first output portion 46b of the first latch circuit 46 to the first input portion 48a of the first NOR circuit 48. Thus, in the first NOR circuit 48, owing to both high-level (1-signal) and low-level (0-signal) input signals, a low-level (0-signal) output signal is output to the first external output terminal 40 as a magnetic field detection signal (on signal). On the other hand, a high-level output signal (1-signal) is output from the first output portion 47b of the second latch circuit 47 to the second external output terminal 41 through the first NOT circuit 49 as an off signal.

Next, the principles of detecting a magnetic field in the (-) direction in the single output mode will be described with reference to FIG. 3.

In the state of the (-) direction external magnetic field detection circuit, as shown in FIG. 3, the (-) magnetic field detection side terminal 43b of the second switch circuit 43 is connected to the input portion 47a of the second latch circuit 47.

As described above, in a state where an external magnetic field in the (-) direction larger than a predetermined magnitude is applied, a high-level signal (1-signal) is generated in the comparator 38 and is then input to the input portion 47a of the second latch circuit 47. As signals A, B, α, β, γ of levels shown in the middle row ("-H" row in the "external magnetic field" column) in Table 1 are input or output, a low-level output signal, which is a magnetic field detection signal (on signal), is output from the first NOR circuit 48 to the first external output terminal 40. Similarly, a low-level output signal, which is a magnetic field detection signal (on signal), is also output from the first NOT circuit 49 to the second external output terminal 41.

Next, when, in the single output mode, no external magnetic field is applied or an external magnetic field smaller than a predetermined magnitude even when a (+) or (-) external magnetic field is applied, as shown in the lower row ("external magnetic field" column in the "non" row) in Table 1, a low-level signal (0-signal) is input to the input portion 46a of the first latch circuit 46 and the input portion 47a of the second latch circuit 47. Ultimately, a high-level signal is output to the first external output terminal 40 and the second external output terminal 41 as an off signal.

As shown in the α, column and γ column in the upper and middle rows in Table 1, both at the time of detecting a (+) magnetic field larger than or equal to a predetermined magnitude and at the time of detecting a (-) magnetic field larger than or equal to a predetermined magnitude, both high-level and low-level input signals are input to the input portions 48a and 48b of the first NOR circuit 48 connected to the first external output terminal 40. Thus, a low-level signal, which is a magnetic field detection signal (on signal), is output from the first NOR circuit 48 both at the time of detecting a (+) magnetic field and at the time of detecting a (-) magnetic field.

Thus, when the first external output terminal 40 is connected to an apparatus side to enable the first external output terminal 40, both the (+) magnetic field detection signal and the (-) magnetic field detection signal may be extracted from the first external output terminal 40. That is, it is possible to set the single output mode compatible with bipolar detection.

Next, the principles of detecting an external magnetic field in the (+) direction in the dual output mode will be described with reference to FIG. 4. Note that in the following description, where a signal at the input portion 46a of the first latch circuit 46 is denoted by "A", a signal at the input portion 47a of the second latch circuit 47 is denoted by "B", a signal at the first output portion 46b of the first latch circuit 46 is denoted by "α", a signal at the first output portion 47b of the second latch circuit 47 is denoted by "β", a signal at the output portion of the second NOR circuit 51 is denoted by "γ", a signal at the first external output terminal 40 is denoted by "OUT1", and a signal at the second external output terminal 41 is denoted by "OUT2", the level of each signal is shown in the following Table 2 (dual output mode).
[Table 2]

**Table 2**

| Dual Output Mode | | | | | | | |
|---|---|---|---|---|---|---|---|
| EXTERNAL MAGNETIC FIELD | A | B | α | β | γ | OUT1 | OUT2 |
| +H | H | L | H | L | L | L (ON) | H (OFF) |
| -H | L | H | L | H | L | H (OFF) | L (ON) |
| NON | L | L | L | L | L | H (OFF) | H (OFF) |

| | | | | | | | |
|---|---|---|---|---|---|---|---|
| L: Low Level H: High Level "H" shown in Table 2 denotes a high-level signal (1-signal), and "L" denotes a low-level signal (0-signal). | | | | | | | |

As described above, in the dual output mode, the change-over switch 53 is in a closed state. Then, in the dual output mode and at the time of detecting a (+) magnetic field, the signal level of each portion is shown in the "external magnetic field" column in the upper row in Table 2.

In the state of the (+) direction external magnetic field detection circuit, as shown in FIG. 4, the (+) magnetic field detection side terminal 43a of the second switch circuit 43 is connected to the input portion 46a of the first latch circuit 46.

As described above, in a state where an external magnetic field in the (+) direction larger than a predetermined magnitude is applied, a high-level signal (1-signal) is generated in the comparator 38 and is then input to the input portion 46a of the first latch circuit 46. On the other hand, because the change-over switch 53 is in a closed state, a low-level input signal is input to the input portion of the second NOT circuit 52, and a high-level input signal is input from the output portion of the second NOT circuit 52 to the second input portion 51b of the second NOR circuit 51. Then, a high-level input signal is input from the second output portion 47c of the second latch circuit 47 to the first input portion 51a of the second NOR circuit 51. As a result, a low-level input signal is input from the output portion of the second NOR circuit 51to the second input portion 48b of the first NOR circuit 48 (γ column in the upper row in Table 2). On the other hand, as shown in the column α in the upper row in Table 2, a high-level input signal is input from the first output portion 46b of the first latch circuit 46 to the first input portion 48a of the first NOR circuit 48. Thus, in the first NOR circuit 48, owing to both high-level (1-signal) and low-level (0-signal) input signals, a low-level (0-signal) output signal is output to the first external output terminal 40 as a magnetic field detection signal (on signal). On the other hand, a high-level signal (1-signal) is output from the first output portion 47b of the second latch circuit 47 to the second external output terminal 41 through the first NOT circuit 49 as an off signal.

Next, the principles of detecting an external magnetic field in the (-) direction in the dual output mode will be described with reference to FIG. 5.

In the state of the (-) direction external magnetic field detection circuit, as shown in FIG. 5, the (-) magnetic field detection side terminal 43b of the second switch circuit 43 is connected to the input portion 47a of the second latch circuit 47.

As described above, in a state where an external magnetic field in the (-) direction larger than a predetermined magnitude is applied, a high-level signal (1-signal) is generated from the comparator 38 and is then input to the input portion 47a of the second latch circuit 47. On the other hand, because the change-over switch 53 is in a closed state, a low-level input signal is input to the input portion of the second NOT circuit 52, and a high-level input signal is input from the output portion of the second NOT circuit 52 to the second input portion 51b of the second NOR circuit 51. Then, a low-level input signal is input from the second output portion 47c of the second latch circuit 47 to the first input portion 51a of the second NOR circuit 51. As a result, a low-level input signal is input from the output portion of the second NOR circuit 51to the second input portion 48b of the first NOR circuit 48 (γ column in the middle row ("external magnetic field" column in the "-H" row) in Table 2). On the other hand, as shown in the column α in the middle row in Table 2, a low-level input signal is input from the first output portion 46b of the first latch circuit 46 to the first input portion 48a of the first NOR circuit 48. Thus, in the first NOR circuit 48, owing to both low-level (0-signal) input signals, a high-level (0-signal) output signal is output to the first external output terminal 40 as an off signal. On the other hand, a low-level signal (0-signal) is output from the first output portion 47b of the second latch circuit 47 to the second external output terminal 41 through the first NOT circuit 49 as an on signal.

Next, when, in the dual output mode, no external magnetic field is applied or an external magnetic field smaller than a predetermined magnitude even when a (+) or (-) external magnetic field is applied, as shown in the lower row ("external magnetic field" column in the "non" row) in Table 2, a low-level signal (0-signal) is input to the input portion 46a of the first latch circuit 46 and the input portion 47a of the second latch circuit 47. Ultimately, a high-level signal is output from the first external output terminal 40 and the second external output terminal 41 as an off signal.

As shown in the α column and γ column in the upper row in Table 2, at the time of detecting a (+) magnetic field larger than or equal to a predetermined magnitude, both high-level and low-level input signals are input to the input portions 48a and 48b of the first NOR circuit 48 connected to the first external output terminal 40. Thus, a low-level signal, which is a magnetic field detection signal (on signal), is output from the first NOR circuit 48 at the time of detecting a (+) magnetic field. On the other hand, a high-level signal is output from the second external output terminal 41 as an off signal at the time of detecting a (+) magnetic field.

As shown in the α column and γ column in the middle row in Table 2, at the time of detecting a (-) magnetic field larger than or equal to a predetermined magnitude, a low-level input signal is input to both the input portions 48a and 48b of the first NOR circuit 48 connected to the first external output terminal 40. Thus, a high-level signal is output from the first NOR circuit 48 at the time of detecting a (-) magnetic field as an off signal. On the other hand, a low-level signal, which is a magnetic field detection signal (on signal), is output from the second external output terminal 41 at the time of detecting a (-) magnetic field.

As shown in Table 1 and Table 2, between the single output mode and the dual output mode, only the signal level of the external output terminal 40 at the time of detecting a (-) magnetic field is different among the signal levels of the first external output terminal 40 and second external output terminal 41 and other signal levels are the same. Because the signal level of the first external output terminal 40 at the time of detecting a (-) magnetic field may be output in high level as an off signal, it is possible to extract a magnetic field detection signal from the first external output terminal 40 at the time of detecting a (+) magnetic field and from the second external output terminal 41 at the time of detecting a (-) magnetic field.

Thus, when both the first external output terminal 40 and the second external output terminal 41 are connected to an apparatus side to enable both the first external output terminal 40 and the second external output terminal 41, the (+) magnetic field detection signal may be extracted from the first external output terminal 40, and the (-) magnetic field detection signal may be extracted from the second external output terminal 41. That is, it is possible to set the dual output mode compatible with bipolar detection.

The characteristic portion of the magnetic detector 20 according to the present embodiment will be described. The present embodiment provides the mode switching portion 50 that is able to switch between the single output mode and the dual output mode. In the single output mode, both the (+) magnetic field detection signal and the (-) magnetic field detection signal are output from the first external output terminal 40. In the dual output mode, the (+) magnetic field detection signal is output from the first external output terminal 40 and the (-) magnetic field detection signal is output from the second external output terminal 41.

By providing the mode switching portion 50 in the integrated circuit 22, mode selection is implemented. Particularly, such mode selection may be implemented by providing the single integrated circuit 22 with a simple circuit configuration. This can reduce production cost.

In the present embodiment, as shown in FIG. 2 to FIG. 5, it is desirable that the mode switching portion 50 is formed of a logic circuit because it is possible to implement mode switching with a simple circuit configuration.

In the present embodiment, the logic circuit has the first NOR circuit 48 connected to the first external output terminal 40, and is controlled so that, in the single output mode, both high-level and low-level input signals are input to the two input portions 48a and 48b provided for the NOR circuit 48 even at the time of detecting a (+) magnetic field or at the time of detecting a (-) magnetic field, and then a low-level output signal is output to the first external output terminal 40 as a magnetic field detection signal.

On the other hand, at the time of detecting a (+) magnetic field in the dual output mode, it is controlled so that a low-level output signal, as well as in the single output mode, is output to the first external output terminal 40 as a (+) magnetic field detection signal and, at this time, a high-level signal, which is an off signal, is output to the second external output terminal 41.

In addition, at the time of detecting a (-) magnetic field in the dual output mode, it is controlled so that a low-level input signal, which is inverted from that in the single output mode, is input to the input portion 48b of the NOR circuit 48 and, as a result, a high-level signal, which is an off signal, is output from the NOR circuit 48 to the first external output terminal 40 and, at this time, a low-level output signal, which is the (-) magnetic field detection signal, is output to the second external output terminal 41.

As described above, using the logic circuit, in the single output mode, it is controlled so that both the (+) magnetic field detection signal and the (-) magnetic field detection signal may be output from the first external output terminal 40, while in the dual output mode, it is controlled so that an off signal is definitely output from the second external output terminal 41 when the (+) magnetic field detection signal is output from the first external output terminal 40, and an off signal is definitely output from the first external output terminal 40 when the (-) magnetic field detection signal is output from the second external output terminal 41.

Switching between the above described single output mode and the dual output mode is performed through switching operation of the change-over switch 53 as shown in FIG. 2 to FIG. 5. In the present embodiment, a signal input to the second input portion 48b of the first NOR circuit 48 is inverted through the above switching operation (see the γ column in the middle row in Table 1 and Table 2) to switch between the single output mode and the dual output mode.

Switching operation of the change-over switch 53 may be, for example, switched by artificial operation from external or may be switched through program control.

The bipolar detection-compatible magnetic detector 20 according to the present embodiment may be, for example, used for open-close detection of a folding cellular phone.

As shown in FIG. 12, the folding cellular phone 90 includes a first member 91 and a second member 92. The first member 91 is a screen display side, and the second member 92 is an operating body side. A liquid crystal display, a receiver, or the like, is provided on a surface of the first member 91, facing the second member 92. Various buttons, a microphone, and the like, are provided on a surface of the second member 92, facing the first member 91. FIG. 12 shows a state where the folding cellular phone 90 is closed. As shown in FIG. 12, a magnet 94 is the internals of the first member 91, and the magnetic detector 20 according to the present embodiment is the internals of the second member 92. In the closed state shown in FIG. 12, the magnet 94 and the magnetic detector 20 are located so as to face each other. Alternatively, the magnetic detector 20 may be located at a position deviated from the position facing the magnet 94 in a direction parallel to a direction in which an external magnetic field enters.

In FIG. 12, an external magnetic field (+H) in the (+) direction emitted from the magnet 94 is transmitted to the magnetic detector 20, and the magnetic detector 20 detects the external magnetic field (+H) to thereby detect that the folding cellular phone 90 is in the closed state.

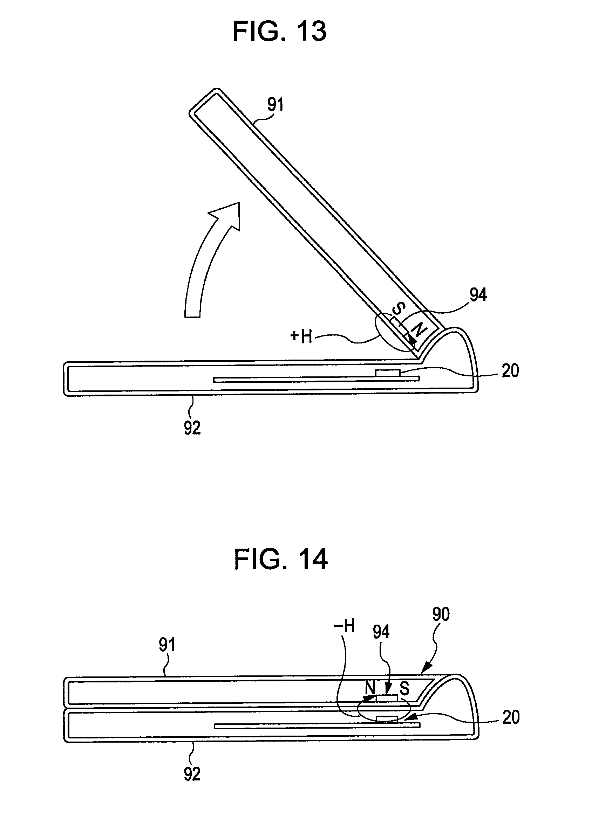

On the other hand, as shown in FIG. 13, when the folding cellular phone 90 is opened, as the first member 91 leaves the second member 92, the magnitude of the external magnetic field (+H) transmitted to the magnetic detector 20 gradually decreases and ultimately the external magnetic field (+H) transmitted to the magnetic detector 20 becomes zero. When the magnitude of the external magnetic field (+H) transmitted to the magnetic detector 20 is smaller than or equal to a predetermined magnitude, an open state of the folding cellular phone 90 is detected, and, for example, a liquid crystal display or a backlight on the back side of operating buttons are controlled for illumination by a control portion of the internals in the cellular phone 90.

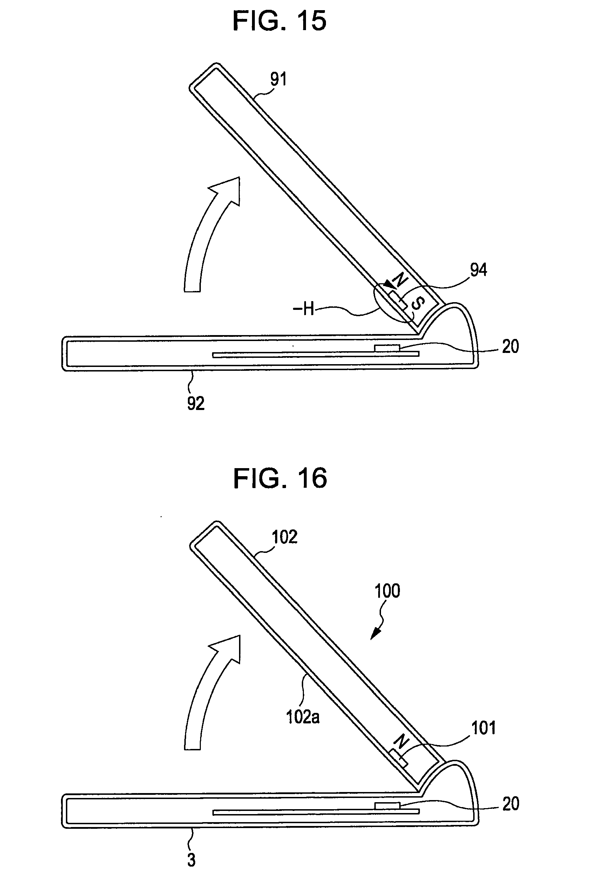

The magnetic detector 20 is a bipolar-compatible sensor. That is, in FIG. 12, the north pole of the magnet 94 is located at the left side in the drawing and the south pole of the magnet 94 is located at the right side in the drawing; however, when the polarities are interchanged as shown in FIG. 14 (the north pole is at the right side in the drawing, and the south pole is at the left side in the drawing), the direction of the external magnetic field (-H) applied to the magnetic detector 20 is inverted from the direction of the external magnetic field (+H) shown in FIG. 1. In the present embodiment, in the above case as well, when the cellular phone 90 is opened, as shown in FIG. 15, from the state where the folding cellular phone 90 is closed as shown in FIG. 14, the open motion is appropriately detected.

Thus, because the magnet 94 may be arranged irrespective of polarity of an external magnetic field, there are no restrictions on arrangement of the magnet 94. This make it easy to assemble.

In the above described open-close detecting method, even when the direction of an external magnetic field cannot be identified, it is only necessary that only a variation in external magnetic field can be detected in bipolar. That is, it is possible to use only the first external output terminal 40 by switching into the single output mode in the present embodiment.

Alternatively, as will be described below, when different functions are started depending on the direction of an external magnetic field as in the case of a turnover-type folding cellular phone 100, it is controlled to switch into the dual output mode to enable the external output terminals 40 and 41 to respectively detect the (+) magnetic field detection signal and the (-) magnetic field detection signal.

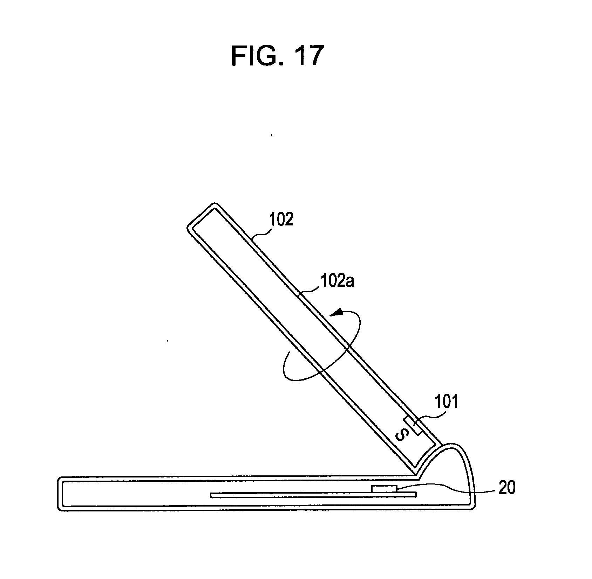

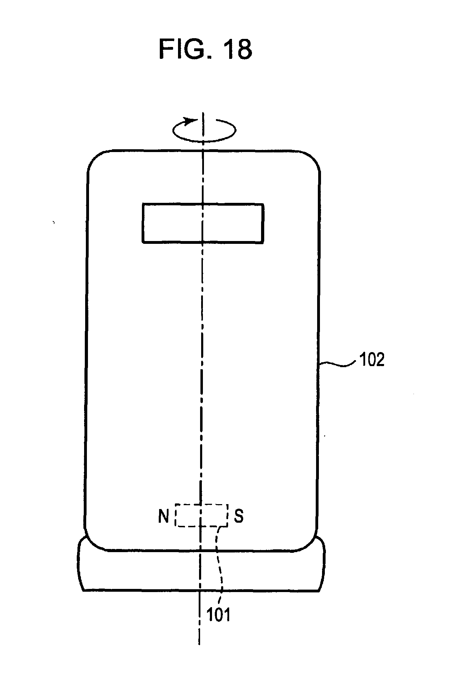

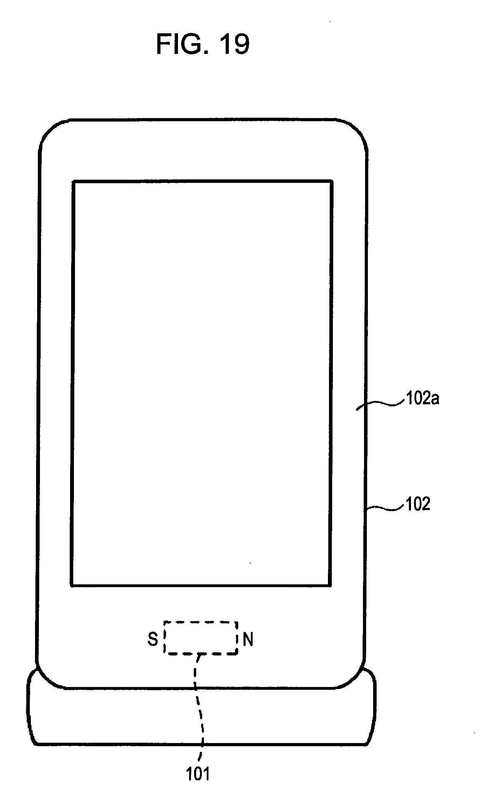

When the folding cellular phone 100 is opened as shown in FIG. 16, as described with reference to FIG. 13 and FIG. 15, the open motion of the cellular phone 100 is detected on the basis of a variation in strength of an external magnetic field applied to the magnetic detector 20. The arrangement of a magnet 101 at the time in FIG. 16 is as shown in a plan view of FIG. 18. A first member 102 of the cellular phone 100 is rotated by 180 degrees about the rotation axis, and in the state shown in FIG. 16, a screen display surface 102a, which is an inner surface of the first member 102, is oriented toward the outer side as shown in FIG. 17 and FIG. 19. At this time, as shown in FIG. 19, the direction of the magnet 101 is inverted from the state of arrangement shown in FIG. 18. For example, when a camera function is started by turning over the first member 102, the magnetic detector 20 needs to detect inversion of the direction of the magnet 101 in addition to the open-close detection function of detecting whether the cellular phone 100 is opened or closed as shown in FIG. 16. In the magnetic detector 20 according to the present embodiment, the (+) magnetic field detection signal and the (-) magnetic field detection signal are identified owing to the dual output mode shown in FIG. 4 and FIG. 5 to thereby make it possible to detect the direction of the magnetic field of the magnet 101.

The configuration of the sensor portion 21 in the present embodiment is an example. As long as the sensor portion 21 varies its electrical characteristic against a variation in magnetic field strength of the external magnetic field in the (+) direction and a variation in magnetic field strength of the external magnetic field in the (-) direction, a magnetosensitive element may, for example, employ a magnetic impedance element or a Hall element instead of a magnetoresistance element; however, when using the magnetoresistance element, it is desirable because bipolar-compatible type may be implemented with a simple circuit configuration as shown in FIG. 1.

In the present embodiment, the first bridge circuit BC3 detects an external magnetic field in the (+) direction, and the second bridge circuit BC4 detects an external magnetic field in the (-) direction. Thus, it is desirable in terms of reduction in the number of elements because the external magnetic fields in the (+) direction and in the (-) direction are detected by the two bridge circuits BC3 and BC4, and the series circuit shared by the bridge circuits is present.

However, in the element configuration of the sensor portion 21 in the present embodiment, the fifth and sixth resistance elements 31 and 34 that are shared by the first bridge circuit BC3 and the second bridge circuit BC4 are fixed resistances that do not vary in resistance value against an external magnetic field, and a differential potential of the first bridge circuit BC3 and a differential potential of the second bridge circuit BC4 occur with respect to a fixed potential at the third output extracting portion 33, so the differential potentials are smaller as compared with the existing sensor configuration shown in FIG. 20.

Thus, in order to obtain a differential potential equivalent to that in the case of the existing sensor configuration, the fifth resistance element 31 shown in FIG. 1 and FIG. 2 may be formed of a magnetoresistance element similar to the first magnetoresistance element 23 arranged in the first series circuit 26, and the sixth resistance element 32 may be formed of a magnetoresistance element similar to the second magnetoresistance element 27 arranged in the second series circuit 30.

Alternatively, the second resistance element 24 connected to the first series circuit 26 and the fourth resistance element 28 connected to the second series circuit 30, as shown in FIG. 1 and FIG. 2, are fixed resistances that do not vary in resistance value against an external magnetic field; however, for example, when the second resistance element 24 is formed of a magnetoresistance element that varies in electric resistance against an external magnetic field in the (+) direction but a variation in resistance value against a variation in magnetic field strength of the external magnetic field exhibits an opposite tendency with respect to that of the first magnetoresistance element 23, and the fourth resistance element 28 is formed of a magnetoresistance element that varies in electric resistance against an external magnetic field in the (-) direction but a variation in resistance value against a variation in magnetic field strength of the external magnetic field exhibits an opposite tendency with respect to the second magnetoresistance element 27, it is desirable because a differential potential may be increased and favorable detection sensitivity may be obtained.

In the embodiment shown in FIG. 1 and FIG. 2, in the first bridge circuit BC3 formed of the first series circuit 26 and the third series circuit 34 and in the second bridge circuit BC4 formed of the second series circuit 30 and the third series circuit 34, when increasing gradually in the (+) direction and in the (-) direction with respect to zero external magnetic field (non-magnetic field state), the tendency of a variation in differential potential is the same between when the external magnetic field in the (+) direction is applied and when the external magnetic field in the (-) direction is applied. With the same tendency of variation in differential potential in this way, it is not necessary to appropriately vary the Schmidt trigger input value of the comparator 38 between when an external magnetic field in the (+) direction is applied and when an external magnetic field in the (-) direction is applied. Thus, control is easy, and it is sufficient when the single comparator 38 is used.

In addition, in the present embodiment, the common third series circuit 34 is used in the first bridge circuit BC3 and in the second bridge circuit BC4. Thus, it is advantageous in that the number of elements that constitute the sensor portion 21 may be reduced; instead, it is also applicable that the sensor portion 21 is configured so that, using the two independent bridge circuits shown in FIG. 20, one detects an external magnetic field in the (+) direction and the other detects an external magnetic field in the (-) direction.

In addition, it is selectable whether a bias magnetic field is given to the magnetoresistance element. It is not necessary to supply a bias magnetic field to the free magnetic layer that constitutes the magnetoresistance element; however, when the bias magnetic field is supplied, for example, magnetizations of the fixed magnetic layer and the free magnetic layer are controlled so as to be perpendicular to each other in a non-magnetic state.

In addition, the circuit configuration of the mode switching portion 50 in the present embodiment is an example and should not be limited to it. However, with the mode switching portion 50 that uses the logic circuit shown in FIG. 2 to FIG. 5, it is possible to simplify the circuit configuration with which both the single output mode and the dual output mode may be obtained. Particularly, when switching between the single output mode and the dual output mode may be performed through switching operation of the change-over switch 53, it is desirable because mode switching may be easily performed.

In addition, as shown in FIG. 2 to FIG. 5, when the change-over switch 53 is closed in the single output mode, and is opened in the dual output mode, the second NOT circuit 52 is not necessary.

Note that in the present embodiment, the first NOR circuit 48 is connected to the first external output terminal 40; instead, an OR circuit is connected and, then, signal levels at various portions may be adjusted in the single output mode and in the dual output mode.

In addition, in the present embodiment, low-level and high-level signals output from the first external output terminal 40 and the second external output terminal 41 are respectively set as a magnetic field detection signal and an off signal; instead, it is also applicable that signal levels at various portions are adjusted and then a high level is set as a magnetic field detection signal and a low level is set as an off signal.

In addition, the magnetic detector 20 according to the present embodiment may be used for open-close detection, or the like, of a portable electronic device, such as a game machine, other than open-close detection of the folding cellular phone. The present embodiment may be used in applications, other than the open-close detection, that require the bipolar detection-compatible magnetic detector 20.

### Brief Description of Drawings

[FIG. 1] FIG. 1 is a circuit configuration diagram of a magnetic detector according to the present embodiment;
[FIG. 2] FIG. 2 is a partially enlarged view that shows the circuit configuration of a mode switching portion in the present embodiment, and is a view that shows a circuit state at the time of detecting a (+) magnetic field in a (+) direction in a single output mode;
[FIG. 3] FIG. 3 is a partially enlarged view that shows the circuit configuration of the mode switching portion in the present embodiment, and is a view that shows a circuit state at the time of detecting a (-) magnetic field in a (-) direction in the single output mode;
[FIG. 4] FIG. 4 is a partially enlarged view that shows the circuit configuration of the mode switching portion in the present embodiment, and is a view that shows a circuit state at the time of detecting a (+) magnetic field in the (+) direction in a dual output mode;
[FIG. 5] FIG. 5 is a partially enlarged view that shows the circuit configuration of the mode switching portion in the present embodiment, and is a view that shows a circuit state at the time of detecting a (-) magnetic field in the (-) direction in the dual output mode;
[FIG. 6] FIG. 6 is a graph (R-H curve) for illustrating the hysteresis characteristic of a first magnetoresistance element;
[FIG. 7] FIG. 7 is a graph (R-H curve) for illustrating the hysteresis characteristic of a second magnetoresistance element;
[FIG. 8] FIG. 8 is a partially enlarged perspective view of the magnetic detector 20 that shows the shape of resistance elements of a sensor portion of the magnetic detector according to the present embodiment;
[FIG. 9] FIG. 9 is a partially cross-sectional view of the magnetic detector, taken along the line A-A in the thickness direction in FIG. 8, as viewed in an arrow direction;
[FIG. 10] FIG. 10 is a partially cross-sectional view that shows the layer structures of the first magnetoresistance element and the second magnetoresistance element;
[FIG. 11] FIG. 11 is a partially cross-sectional view for mainly illustrating the layer structures of fixed resistance elements;
[FIG. 12] FIG. 12 is an example for illustrating an application of the magnetic detector according to the present embodiment (which is a partially schematic view of a folding cellular phone having the internals of the magnetic detector, showing a state where the phone is closed);
[FIG. 13] FIG. 13 is an example for illustrating an application of the magnetic detector according to the present embodiment (which is a partially schematic view of the folding cellular phone having the internals of the magnetic detector, showing a state where the phone is open);
[FIG. 14] FIG. 14 is an example for illustrating an application of the magnetic detector according to the present embodiment (which is a partially schematic view of the folding cellular phone having the internals of the magnetic detector, showing a state where the arrangement of a magnet is inverted from that of FIG. 12 and the phone is closed);
[FIG. 15] FIG. 15 is an example for illustrating an application of the magnetic detector according to the present embodiment (which is a partially schematic view of the folding cellular phone having the internals of the magnetic detector, showing a state where the arrangement of a magnet is inverted from FIG. 13 and the phone is open);
[FIG. 16] FIG. 16 is an example for illustrating an application of the magnetic detector according to the present embodiment (which is a partially schematic view of the folding cellular phone having the internals of the magnetic detector, showing a state where the phone is open);
[FIG. 17] FIG. 17 is an example for illustrating an application of the magnetic detector according to the present embodiment (which is a partially schematic view of the folding cellular phone having the internals of the magnetic detector, showing a state where a first member is turned over) ;
[FIG. 18] FIG. 18 is an example for illustrating an application of the magnetic detector according to the present embodiment (which is a partially plan view of FIG. 16 of the folding cellular phone having the internals of the magnetic detector);
[FIG. 19] FIG. 19 is an example for illustrating an application of the magnetic detector according to the present embodiment (which is a partially plan view of FIG. 18 of the folding cellular phone having the internals of the magnetic detector); and
[FIG. 20] FIG. 20 is a circuit configuration diagram of an existing magnetic detector.

### Reference Numerals

- 20: magnetic detector
- 21: sensor portion
- 22: integrated circuit (IC)
- 23: first magnetoresistance element (first resistance element)
- 24: fixed resistance element (second resistance element)
- 25: first output extracting portion
- 26: first series circuit
- 27: second magnetoresistance element (third resistance element)
- 28: fixed resistance element (fourth resistance element)
- 29: second output extracting portion
- 30: second series circuit
- 31: fixed resistance element (fifth resistance element)
- 32: fixed resistance element (sixth resistance element)
- 33: third output extracting portion
- 34: third series circuit
- 35: differential amplifier
- 36: first switch circuit (first connection switching portion)
- 38: comparator
- 39: input terminal
- 40: first external output terminal
- 41: second external output terminal
- 42: ground terminal
- 43: second switch circuit
- 46, 47: latch circuit
- 48: first NOR circuit
- 49: first NOT circuit
- 50: mode switching portion
- 51: second NOR circuit
- 52: second NOT circuit
- 53: change-over switch
- 62: antiferromagnetic layer
- 63: fixed magnetic layer (first magnetic layer)
- 64: nonmagnetic interlayer
- 65, 67: free magnetic layer (second magnetic layer)
- 78, 80: insulating layer
- 81: molded resin
- 83: clock circuit
- 90, 100: folding cellular phone
- 91, 102: first member
- 92: second member
- 94, 101: magnet

## Claims

1. A magnetic detector (20) comprising:
a sensor portion (21) of which the electrical characteristic varies against a variation in magnetic field strength of an external magnetic field in a (+) direction and a variation in magnetic field strength of an external magnetic field in a (-) direction opposite to the (+) direction; and
an integrated circuit (22) that is connected to the sensor portion (21) and that generates and outputs a (+) magnetic field detection signal and a (-) magnetic field detection signal on the basis of the electrical variation, wherein
the integrated circuit (22) includes
a first external output terminal (40);
a second external output terminal (41); and
a mode switching portion (50)
wherein the mode switching portion (50) is able to switch between
a single output mode, in which both the (+) magnetic field detection signal and the (-) magnetic field detection signal are output from the first external output terminal (40), and
a dual output mode, in which the (+) magnetic field detection signal is output from the first external output terminal (40) and the (-) magnetic field detection signal is output from the second external output terminal (41); and
the mode switching portion (50) includes a logic circuit (48, 49, 51, 52) having a NOR circuit (48) or an OR circuit connected to the first external output terminal (40), **characterized in that**
the mode switching portion is configured such that when in the single output mode, both high-level and low-level input signals are input to two input portions of the NOR circuit (48) or the OR circuit even at the time of detecting a (+) magnetic field or at the time of detecting a (-) magnetic field and then the same level output signals are output to the first external output terminal (40) as the (+) magnetic field detection signal and the (-) magnetic field detection signal, wherein
the mode switching portion is configured such that when in the dual output mode and at the time of detecting a (+) magnetic field, the (+) magnetic field detection signal is output from the first external output terminal (40), and an output signal of a level inverted from the (+) magnetic field detection signal is output from the second external output terminal (41) as an off signal, and the mode switching signal is configured such that when in the dual output mode and at the time of detecting a (-) magnetic field, the (-) magnetic field detection signal is output from the second external output terminal (41), and an input signal of a level inverted from that in the single output mode is input to one of the two input portions of the NOR circuit (48) or the OR circuit, and then an output signal of a level inverted from the (-) magnetic field detection signal is output from the first external output terminal (40) as an off signal.

2. The magnetic detector (20) according to Claim 1, wherein the mode switching portion (50) has a change-over switch (53) and wherein the single output mode and the dual output mode are switchable through switching operation of the change-over switch (53).

3. The magnetic detector (20) according to Claim 1 or 2, wherein a change-over switch (53) is connected to the one of the input portions of the NOR circuit (48) and the OR circuit and wherein a signal level input to the NOR circuit (48) or the OR circuit is inverted through switching operation of the change-over switch (53) to thereby switch between the single output mode and the dual output mode.

4. The magnetic detector (20) according to any one of Claims 1 to 3, wherein the sensor portion (21) includes
a first circuit portion for detecting a (+) magnetic field, which has a first magnetoresistance element (23) the electric resistance of which varies on the basis of a variation in magnetic field strength of an external magnetic field only in the (+) direction; and
a second circuit portion for detecting a (-) magnetic field, which has a second magnetoresistance element (27) the electric resistance of which varies on the basis of a variation in magnetic field strength of an external magnetic field only in the (-) direction opposite to the (+) direction.

5. A magnetic detector (20) comprising:
a sensor portion (21) of which the electrical characteristic varies against a variation in magnetic field strength of an external magnetic field in a (+) direction and a variation in magnetic field strength of an external magnetic field in a (-) direction opposite to the (+) direction; and
an integrated circuit (22) that is connected to the sensor portion (21) and that generates and outputs a (+) magnetic field detection signal and a (-) magnetic field detection signal on the basis of the electrical variation, wherein
the integrated circuit (22) includes
a first external output terminal (40);
a second external output terminal (41); and
a mode switching portion (50)
**characterized in that** the mode switching portion (50)
is able to switch between
a single output mode, in which both the (+) magnetic field detection signal and the (-) magnetic field detection signal are output from the first external output terminal (40), and
a dual output mode, in which the (+) magnetic field detection signal is output from the first external output terminal (40) and the (-) magnetic field detection signal is output from the second external output terminal (41); and
the sensor portion (21) includes
a first circuit portion for detecting a (+) magnetic field, which has a first magnetoresistance element (23) the electric resistance of which varies on the basis of a variation in magnetic field strength of an external magnetic field only in the (+) direction; and
a second circuit portion for detecting a (-) magnetic field, which has a second magnetoresistance element (27) the electric resistance of which varies on the basis of a variation in magnetic field strength of an external magnetic field only in the (-) direction opposite to the (+) direction.

## Patentansprüche

1. Magnetdetektor (20) aufweisend:
eine Sensorbereich (21) dessen elektrische Eigenschaft sich mit einer Variation der Magnetfeldstärke eines äußeren Magnetfeldes in einer (+) Richtung und einer Variation einer Magnetfeldstärke eines äußeren Magnetfeldes in einer (-) Richtung, die der (+) Richtung entgegengesetzt ist, ändert; und
eine integrierte Schaltung (22), die mit dem Sensorbereich (21) verbunden ist und die auf der Basis der elektrischen Änderung ein (+) Magnetfelderkennungssignal und ein (-) Magnetfelderkennungssignal ausgibt, wobei
die integrierte Schaltung (22) enthält:
einen ersten äußeren Ausgangsanschluss (40);
einen zweiten äußeren Ausgangsanschluss (41); und
einen Modusumschaltbereich (50),
wobei der Modusumschaltbereich (50)
in der Lage ist, umzuschalten zwischen
einem Einzel-Ausgabemodus, in dem sowohl das (+) Magnetfelderkennungssignal als auch das (-) Magnetfelderkennungssignal von dem ersten äußeren Ausgangsanschluss (40) ausgegeben werden, und
einen Dual-Ausgabemodus, in dem das (+) Magnetfelderkennungssignal von dem ersten äußeren Ausgangsanschluss (40) ausgegeben wird, und das (-) Magnetfelderkennungssignal von dem zweiten äußeren Ausgangsanschluss (41) ausgegeben wird; und
der Modusumschaltbereich (50) eine mit dem ersten äußeren Ausgangsanschluss (40) verbundene logische Schaltung (48, 49, 51, 52) enthält, die eine NOR-Schaltung (48) oder eine OR-Schaltung aufweist,
**dadurch gekennzeichnet, dass**
der Modusumschaltbereich so eingerichtet ist, dass
im Einzel-Ausgabemodus ein Eingangssignal mit hohem Niveau und ein Eingangssignal mit niedrigem Niveau in die beiden Eingangsbereiche der NOR-Schaltung (48) oder der OR-Schaltung eingegeben werden, selbst wenn zu diesem Zeitpunkt ein (+) Magnetfeld detektiert wird, oder zu diesem Zeitpunkt ein (-) Magnetfeld detektiert wird, und dann Ausgangssignale mit dem gleichen Niveau an den ersten äußeren Ausgangsanschluss (40) als (+) Magnetfelderkennungssignal und (-) Magnetfelderkennungssignal ausgegeben werden, wobei
der Modusumschaltbereich derart eingerichtet ist, dass
im Dual-Ausgabemodus zum Zeitpunkt des Detektierens eines (+) Magnetfeldes das (+) Magnetfelderkennungssignal von dem ersten äußeren Ausgangsanschluss (40) ausgegeben wird, und ein Ausgangssignal mit einem gegenüber dem (+) Magnetfelderkennungssignal invertierten Niveau von dem zweiten äußeren Ausgangsanschluss (41) als ein Aus-Signal ausgegeben wird, und
das Modusumschaltsignal derart eingerichtet ist, dass
im Dual-Ausgabemodus zu einem Zeitpunkt des Detektierens eines (-) Magnetfeldes, das (-) Magnetfelderkennungssignal von dem zweiten äußeren Ausgangsanschluss (41) ausgegeben wird, und ein Eingangssignal mit einem Niveau, das gegenüber dem des Einzel-Ausgabemodus invertiert ist, in einen der beiden Eingangsbereiche der NOR-Schaltung (48) oder der OR-Schaltung eingegeben wird, und dann ein Ausgangssignal mit einem Niveau, das gegenüber dem (-) Magnetfelderkennungssignal invertiert ist, von dem ersten äußeren Ausgangsanschluss (40) als Aus-Signal ausgegeben wird.

2. Magnetdetektor (20) nach Anspruch 1, wobei der Modusumschaltsignalbereich (50) einen Umschaltschalter (53) hat, und wobei
der Einzel-Ausgabemodus und der Dual-Ausgabemodus durch einen Umschaltvorgang des Umschaltschalters (53) umschaltbar sind.

3. Magnetdetektor (20) nach Anspruch 1 oder 2, wobei ein Umschaltschalter (53) mit einem der Eingangsbereiche der NOR-Schaltung (48) oder der OR-Schaltung verbunden ist, und wobei
eine Signalniveaueingabe in die NOR-Schaltung (48) oder die OR-Schaltung durch einen Umschaltvorgang des Umschaltschalters (53) invertiert wird, um dadurch zwischen dem Einzel-Ausgabemodus und dem Dual-Ausgabemodus umzuschalten.

4. Magnetdetektor (20) nach einem der Ansprüche 1 bis 3, wobei der Sensorbereich (21) umfasst:
einen ersten Schaltungsbereich zum Erkennen eines (+) Magnetfeldes, der ein erstes Magnetwiderstandselement (23) hat, dessen elektrischer Widerstand sich nur auf der Basis einer Veränderung einer magnetischen Feldstärke eines äußeren Magnetfeldes in der (+) Richtung ändert; und
einen zweiten Schaltungsbereich zum Erkennen eines (-) Magnetfeldes, der ein zweites Magnetwiderstandselement (27) hat, dessen elektrischer Widerstand sich nur auf der Basis einer Veränderung der magnetischen Feldstärke eines äußeren Magnetfeldes in der (-) Richtung, die der (+) Richtung entgegengesetzt ist, ändert.

5. Magnetdetektor (20) aufweisend:
einen Sensorbereich (21), dessen elektrische Eigenschaft sich aufgrund einer Variation einer Magnetfeldstärke eines äußeren Magnetfeldes in einer (+) Richtung und einer Variation einer Magnetfeldstärke eines äußeren Magnetfeldes in einer (-) Richtung, die der (+) Richtung entgegengesetzt ist, ändert; und
eine integrierte Schaltung (22), die mit dem Sensorbereich (21) verbunden ist, und die auf der Basis der elektrischen Veränderung ein (+) Magnetfelderkennungssignal und ein (-) Magnetfelderkennungssignal erzeugt und ausgibt,
wobei die integrierte Schaltung (22) enthält:
einen ersten äußeren Ausgangsanschluss (40);
einen zweiten äußeren Ausgangsanschluss (41); und
einen Modusumschaltbereich (50),
**dadurch gekennzeichnet, dass** der Modusumschaltbereich (50) in der Lage ist, umzuschalten zwischen
einem Einzel-Ausgabemodus, in dem sowohl das (+) Magnetfelderkennungssignal als auch das (-) Magnetfelderkennungssignal vom ersten äußeren Ausgangsanschluss (40) ausgegeben werden, und
einen Dual-Ausgabemodus, in dem das (+) Magnetfelderkennungssignal von dem ersten Ausgangsanschluss (40) ausgegeben wird, und das (-) Magnetfelderkennungssignal von dem zweiten Ausgangsanschluss (41) ausgegeben wird; und, dass
der Sensorbereich (21) enthält:
einen ersten Schaltungsbereich zum Erkennen eines (+) Magnetfeldes, der ein erstes Magnetwiderstandselement (23) hat, dessen elektrischer Widerstand sich nur auf der Basis einer Veränderung der Magnetfeldstärke eines äußeren Magnetfeldes in der (+) Richtung ändert; und
einen zweiten Schaltungsbereich zum Erkennen eines (-) Magnetfeldes, der ein zweites Magnetwiderstandselement (27) hat, dessen elektrischer Widerstand sich nur auf der Basis einer Veränderung der Magnetfeldstärke eines äußeren Magnetfeldes in der (-) Richtung, die der (+) Richtung entgegengesetzt ist, ändert.

## Revendications

1. Détecteur magnétique (20) comportant :
une partie formant capteur (21) dont la caractéristique électrique varie en fonction d'une variation d'intensité de champ magnétique d'un champ magnétique externe dans un sens (+) et d'une variation d'intensité de champ magnétique d'un champ magnétique externe dans un sens (-) opposé au sens (+) ; et)
un circuit intégré (22) qui est connecté à la partie formant capteur (21) et qui produit et délivre un signal de détection de champ magnétique (+) et un signal de détection de champ magnétique (-) d'après la variation électrique, dans lequel
le circuit intégré (22) comprend
une première borne extérieure de sortie (40) ;
une seconde borne extérieure de sortie (41) ; et
un moyen de commutation de mode (50),
le moyen de commutation de mode (50) étant apte à commuter entre
un mode de délivrance unique dans lequel le signal de détection de champ magnétique (+) et le signal de détection de champ magnétique (-) sont délivrés par la première borne extérieure de sortie (40), et
un mode de délivrance double dans lequel le signal de détection de champ magnétique (+) est délivré par la première borne extérieure de sortie (40) et le signal de détection de champ magnétique (-) est délivré par la seconde borne extérieure de sortie (41) ; et
le moyen de commutation de mode (50) comprend un circuit logique (48, 49, 51, 52) à circuit NON/OU (48) ou circuit OU connecté à la première borne extérieure de sortie (40), **caractérisé en ce que**
le moyen de commutation de mode est conçu de façon que
lorsque le mode de délivrance unique est sélectionné, des signaux d'entrée de niveau haut ainsi que des signaux d'entrée de niveau bas soient appliqués à deux entrées du circuit NON/OU (48) ou du circuit OU même à l'instant de la détection d'un champ magnétique (+) ou à l'instant de la détection d'un champ magnétique (-), puis que les signaux de sortie au même niveau soient appliqués à la première borne extérieure de sortie (40) en tant que signal de détection de champ magnétique (+) et signal de détection de champ magnétique (-),
le moyen de commutation de mode étant conçu de façon que
lorsque le mode de délivrance double est sélectionné et à l'instant de la détection d'un champ magnétique (+), le signal de détection de champ magnétique (+) soit délivré par la première borne extérieure de sortie (40) et qu'un signal de sortie d'un niveau inversé par rapport à celui du signal de détection de champ magnétique (+) soit délivré par la seconde borne extérieure de sortie (41) en tant que signal d'arrêt, et le signal de commutation de mode est conçu de façon que
lorsque le mode de délivrance double est sélectionné et à l'instant de la détection d'un champ magnétique (-), le signal de détection de champ magnétique (-) soit délivré par la seconde borne extérieure de sortie (41) et qu'un signal d'entrée d'un niveau inversé par rapport à celui du mode de délivrance unique soit appliqué à l'une des deux entrées du circuit NON/OU (48) ou du circuit OU, puis qu'un signal de sortie d'un niveau inversé par rapport à celui du signal de détection de champ magnétique (-) soit délivré par la première borne extérieure de sortie (40) en tant que signal d'arrêt.

2. Détecteur magnétique (20) selon la revendication 1, dans lequel le moyen de commutation de mode (50) a un inverseur (53) et dans lequel le mode de délivrance unique et le mode de délivrance double sont commutables par l'intermédiaire d'une manoeuvre de commutation de l'inverseur (53).

3. Détecteur magnétique (20) selon la revendication 1 ou 2, dans lequel un inverseur (53) est connecté à l'une des entrées du circuit NON/OU (48) ou du circuit OU, et dans lequel
un niveau de signal fourni au circuit NON/OU (48) ou au circuit OU est inversé par l'intermédiaire d'une manoeuvre de commutation de l'inverseur (53) pour ainsi commuter entre le mode de délivrance unique et le mode de délivrance double.

4. Détecteur magnétique (20) selon l'une quelconque des revendications 1 à 3, dans lequel la partie formant capteur (21) comprend
une partie formant premier circuit pour détecter un champ magnétique (+), qui a un premier élément magnétorésistant (23) dont la résistance électrique varie en fonction d'une variation de l'intensité de champ magnétique d'un champ magnétique externe uniquement dans le sens (+) ; et
une partie formant second circuit pour détecter un champ magnétique (-), qui a un second élément magnétorésistant (27) dont la résistance électrique varie en fonction d'une variation de l'intensité de champ magnétique d'un champ magnétique externe uniquement dans le sens (-) opposé au sens (+).

5. Détecteur magnétique (20) comportant :
une partie formant capteur (21) dont la caractéristique électrique varie en fonction d'une variation de l'intensité de champ magnétique d'un champ magnétique externe dans un sens (+) et d'une variation de l'intensité de champ magnétique d'un champ magnétique externe dans un sens (-) opposé au sens (+) ; et
un circuit intégré (22) qui est connecté à la partie formant capteur (21) et qui produit et délivre un signal de détection de champ magnétique (+) et un signal de détection de champ magnétique (-) d'après la variation électrique, dans lequel
le circuit intégré (22) comprend
une première borne extérieure de sortie (40) ;
une seconde borne extérieure de sortie (41) ; et
un moyen de commutation de mode (50),
**caractérisé en ce que** le moyen de commutation de mode (50) est apte à commuter entre
un mode de délivrance unique dans lequel le signal de détection de champ magnétique (+) et le signal de détection de champ magnétique (-) sont délivrés par la première borne extérieure de sortie (40), et
un mode de délivrance double dans lequel le signal de détection de champ magnétique (+) est délivré par la première borne extérieure de sortie (40) et le signal de détection de champ magnétique (-) est délivré par la seconde borne extérieure de sortie (41) ; et
la partie formant capteur (21) comprend
une partie formant premier circuit pour détecter un champ magnétique (+), qui a un premier élément magnétorésistant (23) dont la résistance électrique varie en fonction d'une variation de l'intensité de champ magnétique d'un champ magnétique externe uniquement dans le sens (+) ; et
une partie formant second circuit pour détecter un champ magnétique (-), qui a un second élément magnétorésistant (27) dont la résistance électrique varie en fonction d'une variation de l'intensité de champ magnétique d'un champ magnétique externe uniquement dans le sens (-) opposé au sens (+).
